# EUROPEAN PATENT APPLICATION

(11) **EP 3 522 220 A1**
(43) Date of publication of application: **07.08.2019**
(21) Application number: 17855818.5
(22) Date of filing: 19.09.2017
(51) Int. Cl.: H01L 27/146, G02B 7/28, G02B 7/34, G03B 13/36, H04N 5/369

(54) **IMAGING ELEMENT AND FOCUS ADJUSTMENT DEVICE**

(30) Priority: 30.09.2016 JP 2016194624
(71) Applicant: Nikon Corporation, Tokyo 108-6290 (JP)
(72) Inventor: KATO, Shutaro, Tokyo 108-6290 (JP); TAKAGI, Toru, Tokyo 108-6290 (JP); NAKAYAMA, Satoshi, Tokyo 108-6290 (JP); SEO, Takashi, Tokyo 108-6290 (JP); ANDO, Ryoji, Tokyo 108-6290 (JP)
(74) Representative: Hoffmann Eitle
(86) International application number: PCT/JP2017/033707
(87) International publication number: WO 2018/061863

(57) **Abstract**

An image sensor includes a plurality of pixels arranged in a first direction, wherein: each of a first pixel and a second pixel included in the plurality of pixels has a photoelectric conversion unit that photoelectrically converts incident light and generates electric charge, a reflective unit that reflects light that has passed through the photoelectric conversion unit back to the photoelectric conversion unit, and an output unit that outputs electric charge generated by photoelectric conversion by the photoelectric conversion unit; in a plane intersecting the direction in which light is incident, the reflective unit of the first pixel is provided in a region more toward the first direction than the center of the photoelectric conversion unit of the first pixel; in a plane intersecting the direction in which light is incident, the reflective unit of the second pixel is provided in a region more toward the direction opposite to the first direction than the center of the photoelectric conversion unit of the second pixel; at least a portion of the output unit of the first pixel is provided upon the optical path along which light that has passed through the photoelectric conversion unit of the first pixel is incident upon the reflective unit of the first pixel; and at least a portion of the output unit of the second pixel is provided upon the optical path along which light that has passed through the photoelectric conversion unit of the second pixel is incident upon the reflective unit of the second pixel.

## Description

### TECHNICAL FIELD

The present invention relates to an image sensor and to a focus adjustment device.

### BACKGROUND ART

An imaging device is per se known (refer to Patent Document 1) in which a reflecting layer is provided underneath a photoelectric conversion unit, and in which light that has passed through the photoelectric conversion unit is reflected back to the photoelectric conversion unit by this reflecting layer. Signals obtained by this type of photoelectric conversion unit have never been employed for focus detection.

### CITATION LIST

### PATENT LITERATURE

Patent Document 1: Japanese Laid-Open Patent Publication 2010-177704.

### SUMMARY OF INVENTION

An image sensor according to the 1st aspect in which a plurality of pixels are arranged in a first direction, wherein: each of a first pixel and a second pixel included in the plurality of pixels comprises a photoelectric conversion unit that photoelectrically converts incident light and generates electric charge, a reflective unit that reflects light that has passed through the photoelectric conversion unit back to the photoelectric conversion unit, and an output unit that outputs electric charge generated by photoelectric conversion by the photoelectric conversion unit; in a plane intersecting the direction in which light is incident, the reflective unit of the first pixel is provided in a region more toward the first direction than the center of the photoelectric conversion unit of the first pixel; in a plane intersecting the direction in which light is incident, the reflective unit of the second pixel is provided in a region more toward the direction opposite to the first direction than the center of the photoelectric conversion unit of the second pixel; at least a portion of the output unit of the first pixel is provided upon the optical path along which light that has passed through the photoelectric conversion unit of the first pixel is incident upon the reflective unit of the first pixel; and at least a portion of the output unit of the second pixel is provided upon the optical path along which light that has passed through the photoelectric conversion unit of the second pixel is incident upon the reflective unit of the second pixel.

An image sensor according to the 2nd aspect comprises: a photoelectric conversion unit that photoelectrically converts incident light and generates electric charge; a reflective unit that reflects light that has passed through the photoelectric conversion unit back to the photoelectric conversion unit; and an output unit that outputs electric charge generated by photoelectric conversion by the photoelectric conversion unit; wherein at least a part of the output unit is provided upon the optical path along which light that has passed through the photoelectric conversion unit is incident upon the reflective unit.

### BRIEF DESCRIPTION OF DRAWINGS

Fig. 1 is a figure showing the structure of principal portions of a camera;
Fig. 2 is a figure showing an example of several focusing areas;
Fig. 3 is an enlarged view showing a portion of an array of pixels upon an image sensor;
Fig. 4 is several enlarged sectional views of pixels;
Fig. 5 is a figure for explanation of ray bundles incident upon several focus detection pixels;
Fig. 6 is a figure showing a circuit structure of one pixel;
Fig. 7 is a plan view, schematically showing a circuit layout of a number of pixels;
Fig. 8 is two plan views, each schematically showing a circuit layout of a number of pixels;
Fig. 9 is an enlarged sectional view of two pixels;
Fig. 10 is a figure showing a circuit structure of one pixel;
Fig. 11 is a plan view, schematically showing a circuit layout of a number of pixels;
Fig. 12 is a figure showing a circuit structure of a pixel;
Fig. 13 is a plan view, schematically showing a circuit layout of a number of pixels;
Fig. 14 is a plan view, schematically showing a circuit layout of a number of pixels;
Fig. 15 is two plan views, schematically showing a circuit layout of a number of pixels, and the arrangement of their color filters;
Fig. 16 is a plan view, schematically showing a circuit layout of a number of pixels;
Fig. 17 is a figure showing the circuit structures of a total of four pixels that are adjacent in the horizontal direction (i.e. in the row direction);
Fig. 18 is a plan view, schematically showing a circuit layout of a number of pixels;
Fig. 19 is a figure showing the circuit structures of a total of four pixels that are adjacent in the horizontal direction (i.e. in the row direction);
Fig. 20 is a plan view, schematically showing a circuit layout of a number of pixels;
Fig. 21 is a figure showing the circuit structure of a total of eight pixels in four rows and two columns;
Fig. 22 is a plan view, schematically showing a circuit layout of a number of pixels;
Fig. 23 is two plan views, schematically showing a circuit layout of a number of pixels, and the arrangement of their color filters;
Fig. 24 is two plan views, schematically showing a circuit layout of a number of pixels, and the arrangement of their color filters;
Fig. 25 is a plan view, schematically showing a circuit layout of a number of pixels;
Fig. 26 is a plan view, schematically showing a circuit layout of a number of pixels;
Fig. 27 is two plan views, schematically showing a circuit layout of a number of pixels and the arrangement of their color filters;
Fig. 28 is two plan views, schematically showing a circuit layout of a number of pixels and the arrangement of their color filters; and
Fig. 29 is two plan views, schematically showing a circuit layout of a number of pixels and the arrangement of their color filters.

### DESCRIPTION OF EMBODIMENTS

### First Embodiment

An image sensor (imaging element), a focus detection device, and an imaging device according to an embodiment of the present invention will now be explained with reference to the drawings. An interchangeable lens type digital camera (hereinafter termed the "camera 1") will be shown and described as an example of an electronic device to which the image sensor according to this embodiment is mounted, but it would also be acceptable for such an electronic device to be an integrated lens type camera in which the interchangeable lens 3 and the camera body 2 are integrated together.

Moreover, the electronic device is not limited to being a camera 1, it could also be a smart phone, a wearable terminal, a tablet terminal or the like that is equipped with an image sensor.

### Structure of Principal Portions of the Camera

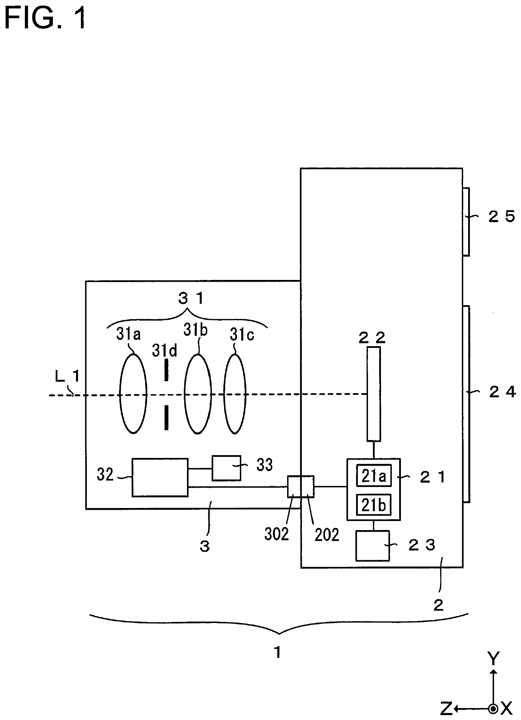

Fig. 1 is a figure showing the structure of principal portions of the camera 1. The camera 1 comprises a camera body 2 and an interchangeable lens 3. The interchangeable lens 3 is installed to the camera body 2 via a mounting portion not shown in the figures. When the interchangeable lens 3 is installed to the camera body 2, a connection portion 202 on the camera body 2 side is connected to a connection portion 302 on the interchangeable lens 3 side, and communication between the camera body 2 and the interchangeable lens 3 becomes possible.

Referring to Fig. 1, light from the photographic subject is incident in the -Z axis direction in Fig. 1 (i.e., in the rightward direction upon the drawing paper). Moreover, as shown by the coordinate axes, the direction orthogonal to the Z axis and outward from the drawing paper will be taken as being the +X axis direction, and the direction orthogonal to the Z axis and to the X axis and upward will be taken as being the +Y axis direction. In the various subsequent figures, coordinate axes that are referred to the coordinate axes of Fig. 1 will be shown, so that the orientations of the various figures can be understood.

### The Interchangeable Lens

The interchangeable lens 3 comprises an imaging optical system (i.e. an image formation optical system) 31, a lens control unit 32, and a lens memory 33. The imaging optical system 31 may include, for example, a plurality of lenses 31a, 31b and 31c including a focus adjustment lens (i.e. a focusing lens) 31c, and a diaphragm 31d, and forms an image of the photographic subject upon an image surface of an image sensor 22 that is provided to the camera body 2.

On the basis of signals outputted from a body control unit 21 of the camera body 2, the lens control unit 32 adjusts the position of the focal point of the imaging optical system 31 by shifting the focus adjustment lens 31c forwards and backwards along the direction of the optical axis L1. The signals outputted from the body control unit 21 during focus adjustment include information specifying the shifting direction of the focus adjustment lens 31c and its shifting amount, its shifting speed, and so on.

Moreover, the lens control unit 32 controls the aperture diameter of the diaphragm 31d on the basis of a signal outputted from the body control unit 21 of the camera body 2.

The lens memory 33 is, for example, built around a non-volatile storage medium or the like. Information relating to the interchangeable lens 3 is recorded in the lens memory 33 as lens information. For example, information related to the position of the exit pupil of the imaging optical system 31 is included in this lens information. The lens control unit 32 performs recording of information into the lens memory 33 and reading out of lens information from the lens memory 33.

### The Camera Body

The camera body 2 comprises the body control unit 21, the image sensor 22, a memory 23, a display unit 24, and an operation member 25. The body control unit 21 is built around a CPU, ROM, RAM and so on, and controls the various sections of the camera 1 on the basis of a control program.

The image sensor 22 is built around a CCD image sensor or a CMOS image sensor. The image sensor 22 receives a ray bundle that has passed through the exit pupil of the imaging optical system 31 upon its image surface, and photoelectrically converts it into an image of the photographic subject (image capture). In this photoelectric conversion process, each of a plurality of pixels that are disposed upon the image surface of the image sensor 22 generates a signal corresponding to the amount of light that it receives. And these signals that are thus generated by the image sensor 22 are read out from the image sensor 22 and sent to the body control unit 21.

It should be understood that both image signals and signals for focus detection are included in the signals generated by the image sensor 22. The details of these image signals and of these focus detection signals will be described hereinafter.

The memory 23 is, for example, built around a recording medium such as a memory card or the like. Image data and audio data and so on are recorded in the memory 23. The recording of data into the memory 23 and the reading out of data from the memory 23 are performed by the body control unit 21. According to commands from the body control unit 21, the display unit 24 displays an image based upon the image data and information related to photographic condition such as the shutter speed, the diaphragm value and so on, and also displays a menu actuation screen and so on. The operation member 25 includes a release button, a record button, setting switches of various types and so on, and outputs actuation signals corresponding to actuation of each of these controls to the body control unit 21.

Moreover, the body control unit 21 described above includes a focus detection unit 21a and an image generation unit 21b. The focus detection unit 21a performs focus detection processing required for automatic focus adjustment (AF) of the imaging optical system 31. A simple explanation of the flow of this focus detection processing will now be given. First, on the basis of the focus detection signals read out from the image sensor 22, the focus detection unit 21a calculates the amount of defocusing by employing a split pupil type phase difference focus detection method. In concrete terms, an amount of positional deviation of images (image deviation) due to a plurality of ray bundles that have passed through different regions of the pupil of the imaging optical system 31 is detected, and the defocusing amount is calculated on the basis of the amount of image deviation that has thus been detected.

And the focus detection unit 21a makes a decision as to whether or not the amount of defocusing is within a permitted value. If the amount of defocusing is within the permitted value, then the focus detection unit 21a determines that the system is adequately focused, and the focus detection process terminates. On the other hand, if the defocusing amount is greater than the permitted value, then the focus detection unit 21 determines that the system is not adequately focused, and sends a command to the lens control unit 32 of the interchangeable lens 3 for shifting that lens by a certain amount related to the defocusing, and then the focus detection process terminates. And, upon receipt of this command from the focus detection unit 21a, the lens control unit 32 performs focus adjustment automatically by causing the focus adjustment lens 31c to be shifted according to the calculated defocusing amount.

On the other hand, the image generation unit 21b of the body control unit 21 generates image data related to the image of the photographic subject on the basis of the image signals read out from the image sensor 22. Moreover, the image generation unit 21b performs predetermined image processing upon the image data that has thus been generated. This image processing may, for example, include per se known image processing such as tone conversion processing, color interpolation processing, contour enhancement processing, and so on.

### Explanation of the Image sensor

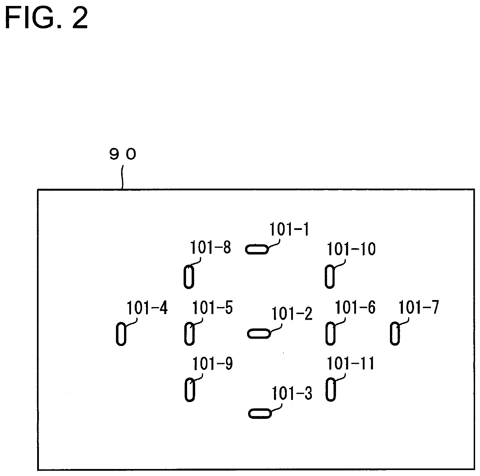

Fig. 2 is a figure showing an example of focusing areas defined on the photographic scene 90. These focusing areas are areas for which the focus detection unit 21a detects amounts of image deviation described above as phase difference information, and they may also be termed "focus detection areas", "range-finding points", or "auto focus (AF) points". In this embodiment, eleven focusing areas 101-1 through 101-11 are set in advance within the photographic scene 90, and the camera is capable of detecting the amount of image deviation in each of these eleven areas. It should be understood that this number of focusing areas 101-1 through 101-11 shown in Fig. 2, and their positions, are only an example. For example, more than eleven such areas could be provided, or fewer. And the focusing areas could be provided in positions different from the positions shown in Fig. 2. Moreover, it would also be acceptable to set the focusing areas 101-1 through 101-11 over the entire photographic scene 90.

The focusing areas 101-1 through 101-11 correspond to the positions at which focus detection pixels 11R, 11L are disposed, as will be described hereinafter.

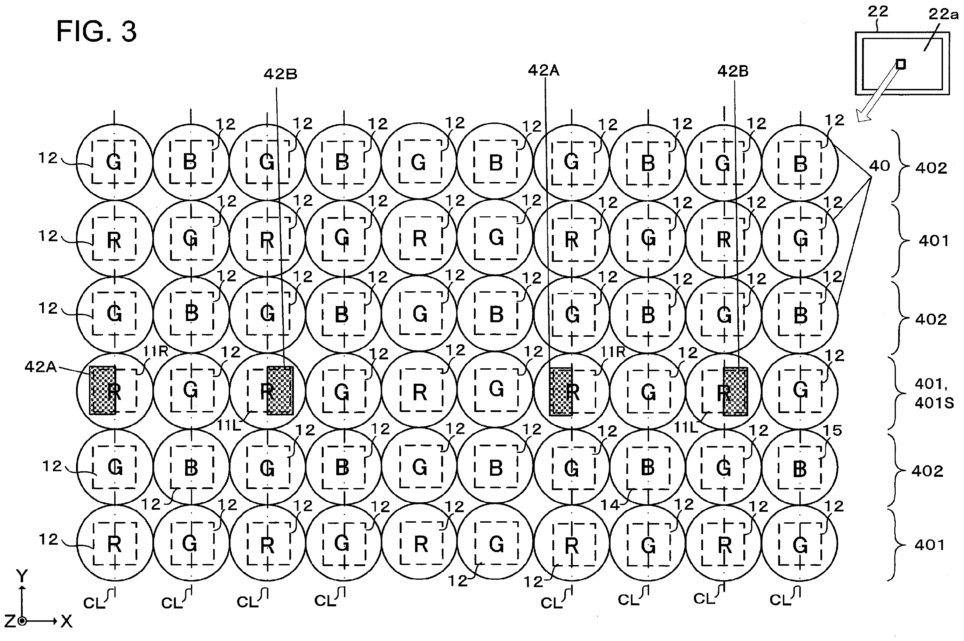

Fig. 3 is an enlarged view of a portion of an array of pixels on the image sensor 22. A plurality of pixels that include photoelectric conversion units are arranged on the image sensor 22 in a two dimensional configuration (for example, along a row direction and a column direction), within a region 22a where the image is generated. To each of the pixels is provided one of three color filters having different spectral sensitivities, for example R (red), G (green), and B (blue). The R color filters principally pass light in a red colored wavelength range. Moreover, the G color filters principally pass light in a green colored wavelength range. And the B color filters principally pass light in a blue colored wavelength range. Due to this, the various pixels have different spectral sensitivity characteristics, corresponding to the color filters provided to them.

On the image sensor 22, pixel columns 401 in which pixels having R and G color filters (hereinafter respectively termed "R pixels" and "G pixels") are arranged alternately, and pixel columns 402 in which pixels having G and B color filters (hereinafter respectively termed "G pixels" and "B pixels") are arranged alternately, are arranged repeatedly in a two dimensional pattern. In this manner, for example, the R pixels, G pixels, and B pixels are arranged according to a Bayer array.

The image sensor 22 includes imaging pixels 12 that are R pixels, G pixels, and B pixels arrayed as described above, and focus detection pixels 11R, 11L that are disposed so as to replace some of the imaging pixels 12. Among the pixel rows 401, the reference symbol 401S is appended to the pixel rows in which focus detection pixels 11R, 11L are disposed. Each of the focus detection pixels 11R, 11L is disposed in a position in which, otherwise, an R pixel would be provided. In other words, the focus detection pixels 11R, 11L all have filters that pass a specific wavelength range.

In Fig. 3, a case is shown by way of example in which the focus detection pixels 11R, 11L are arranged along the row direction (the X axis direction), in other words along the horizontal direction.

The signals that are read out from the imaging pixels 12 of the image sensor 22 are employed as image signals by the body control unit 21. Moreover, the signals that are read out from the focus detection pixels 11R, 11L of the image sensor 22 are employed as focus detection signals by the body control unit 21.

It should be understood that the signals that are read out from the focus detection pixels 11R, 11L of the image sensor 22 may also be employed as image signals by being corrected.

Next, the imaging pixels 12 and the focus detection pixels 11R, 11L will be explained in detail.

### The Imaging Pixels

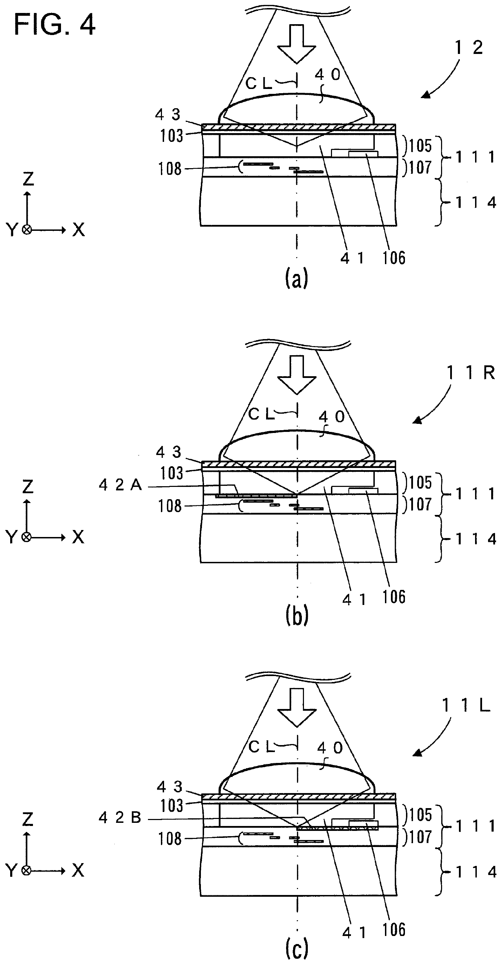

Fig. 4(a) is an enlarged sectional view of one of the imaging pixels 12 of Fig. 3. The line CL is a line drawn through the center of this imaging pixel 12.

As an example, the image sensor 22 may be of the backside illuminated type, in which a first substrate 111 and a second substrate 114 are laminated together via an adhesion layer, not shown in the figures. The first substrate 111 is made as a semiconductor substrate. Moreover, the second substrate 114 is made as a semiconductor substrate or as a glass substrate or the like, and functions as a support substrate for the first substrate 111.

A color filter 43 is provided over the first substrate 111 (on its side in the +Z axis direction) via an anti-reflection layer 103. Moreover, a micro lens 40 is provided over the color filter 43 (on its side in the +Z axis direction). Light is incident upon this imaging pixel 12 from above the micro lens 40 (i.e. from the +Z axis direction) in the direction shown by the white arrow sign (i.e. in the -Z axis direction). The micro lens 40 condenses the incident light onto a photoelectric conversion unit 41 on the first substrate 111.

In relation to the micro lens 40 of this imaging pixel 12, the optical power of the micro lens 40 is determined so that the intermediate position in the thickness direction (i.e. in the Z axis direction) of the photoelectric conversion unit 41 and the position of the pupil of the imaging optical system 31 (i.e., the position of an exit pupil 60 that will be explained hereinafter) are mutually conjugate. The optical power may be adjusted by varying the curvature or varying the refractive index of the micro lens 40. Varying the optical power of the micro lens 40 implies changing the focal length of the micro lens 40. For example, if the curvature of the micro lens 40 is reduced, then its focal length becomes longer. Moreover, if the curvature of the micro lens 40 is increased, then its focal length becomes shorter. If the micro lens 40 is made from a material whose refractive index is lower, then its focal length becomes longer. Moreover, if the micro lens 40 is made from a material whose refractive index is higher, then its focal length becomes shorter. Even further, if the thickness of the micro lens 40 (i.e. its dimension in the Z axis direction) becomes smaller, then its focal length becomes longer. Moreover, if the thickness of the micro lens 40 (i.e. its dimension in the Z axis direction) becomes greater, then its focal length becomes shorter. It should be understood that, when the focal length of the micro lens 40 becomes longer, then the position at which the light incident upon the photoelectric conversion unit 41 is condensed shifts in the direction to become deeper (i.e. shifts in the -Z axis direction). Moreover, when the focal length of the micro lens 40 becomes shorter, then the position at which the light incident upon the photoelectric conversion unit 41 is condensed shifts in the direction to become shallower (i.e. shifts in the +Z axis direction).

According to the structure described above, it is avoided that the ray bundle that has passed through the pupil of the imaging optical system 31 should be incident upon any region outside the photoelectric conversion unit 41, in other words leakage of the ray bundle to neighboring pixels is prevented, so that the amount of light incident upon the photoelectric conversion unit 41 is increased. To put it in another manner, the amount of electric charge generated by the photoelectric conversion unit 41 is increased.

A semiconductor layer 105 and a wiring layer 107 are laminated together in the first substrate 111, and the semiconductor layer 105 is provided with the photoelectric conversion unit 41 and with an output unit 106. The photoelectric conversion unit 41 is, for example, built around a photodiode (PD), and light incident upon the photoelectric conversion unit 41 is photoelectrically converted thereby and electric charge is generated. Light that has been condensed by the micro lens 40 is incident upon the upper surface of the photoelectric conversion unit 41 (i.e. from the +Z axis direction). Moreover, the output unit 106 includes a transfer transistor TX and an amplification transistor AMP and so on that will be described hereinafter. The output unit 106 generates a signal from the electric charge that has been photoelectrically converted by the photoelectric conversion unit 41, and outputs this generated signal to the wiring layer 107.

The wiring layer 107 includes a conductor layer (i.e. a metallic layer) and an insulation layer, and a plurality of wires 108 and vias and so on not shown in the figure are disposed therein. For example, copper or aluminum or the like may be employed for the conductor layer. And the insulation layer may, for example, consist of an oxide layer or a nitride layer or the like. The signal of the imaging pixel 22 that has been outputted from the output unit 106 to the wiring layer 107 is, for example, subjected to signal processing such as A/D conversion and so on by peripheral circuitry not shown in the figures provided on the second substrate 114, and is read out by the body control unit 21 (refer to Fig. 1).

As shown by way of example in Fig. 3, a plurality of the imaging pixels 12 of Fig. 4(a) are arranged along the X axis direction and the Y axis direction, and these are R pixels, G pixels, and B pixels. These R pixels, G pixels, and B pixels all have the structure shown in Fig. 4(a), but with the spectral characteristics of their respective color filters 43 being different from one another.

### The Focus Detection Pixels

Fig. 4(b) is an enlarged sectional view of one of the focus detection pixels 11R of Fig. 3. To structures that are similar to structures of the imaging pixel 12 of Fig. 4(a), the same reference symbols are appended, and explanation thereof will be curtailed. The line CL is a line drawn through the center of this focus detection pixel 11R, in other words drawn along the optical axis of the micro lens 40 and through the center of the photoelectric conversion unit 41. The fact that this focus detection pixel 11R is provided with a reflective unit 42A below the lower surface of its photoelectric conversion unit 41 (i.e. below the surface thereof in the -Z axis direction) is a feature that is different, as compared with the imaging pixel 12 of Fig. 4(a). It should be understood that it would also be acceptable for this reflective unit 42A to be provided as separated in the -Z axis direction from the lower surface of the photoelectric conversion unit 41.The lower surface of the photoelectric conversion unit 41 is its surface on the opposite side from its upper surface upon which light is incident via the micro lens 40. The reflective unit 42A may, for example, be built as a multi-layered structure including a conductor layer made from copper, aluminum, tungsten or the like provided in the wiring layer 107, or as an insulation layer made from silicon nitride or silicon oxide or the like. The reflective unit 42A covers almost half of the lower surface of the photoelectric conversion unit 41 (on the left side of a line CL (i.e. in the -X axis direction from that line)). Due to the provision of the reflective unit 42A, at the left half of the photoelectric conversion unit 41, light that has passed through the photoelectric conversion unit 41 and that is proceeding in the downward direction (i.e. in the -Z axis direction) is reflected back upward by the reflective unit 42A, and is again incident upon the photoelectric conversion unit 41 for a second time. Since this light that is again incident upon the photoelectric conversion unit 41 is photoelectrically converted thereby, accordingly the amount of electric charge that is generated by the photoelectric conversion unit 41 is increased, as compared to the case of an imaging pixel 12 to which no such reflective unit 42A is provided.

In relation to the micro lens 40 of this focus detection pixel 11R, the optical power of the micro lens 40 is determined so that the position of the lower surface of the photoelectric conversion unit 41, in other words the position of the reflective unit 42A, is conjugate to the position of the pupil of the imaging optical system 31 (in other words, to the exit pupil 60 that will be explained hereinafter).

Accordingly, as will be explained in detail hereinafter, along with first and second ray bundles that have passed through first and second regions of the pupil of the imaging optical system 31 being incident upon the photoelectric conversion unit 41, also, among the light that has passed through the photoelectric conversion unit 41, this second ray bundle that has passed through the second pupil region is reflected by the reflective unit 42A, and is again incident upon the photoelectric conversion unit 41 for a second time.

Due to the provision of the structure described above, it is avoided that the first and second ray bundles that have passed through the pupil of the imaging optical system 31 should be incident upon outside the photoelectric conversion unit 41 or should leak to a neighboring pixel, so that the amount of light incident upon the photoelectric conversion unit 41 is increased. To put this in another manner, the amount of electric charge generated by the photoelectric conversion unit 41 is increased.

It should be understood that it would also be acceptable for a part of the wiring 108 formed in the wiring layer 107, for example a part of a signal line connected to the output unit 106, to be also employed as the reflective unit 42A. In this case, the reflective unit 42A would serve both as a reflective layer that reflects light that has passed through the photoelectric conversion unit 41 and is proceeding in the direction downward from the photoelectric conversion unit 41 (i.e. in the -Z axis direction), and also as a signal line that transmits a signal.

In a similar manner to the case with the imaging pixel 12, the signal of the focus detection pixel 11R that has been outputted from the output unit 106 to the wiring layer 107 is subjected to signal processing such as, for example, A/D conversion and so on by peripheral circuitry not shown in the figures provided on the second substrate 114, and is then read out by the body control unit 21 (refer to Fig. 1).

It should be understood that, in Fig. 4(b), it is shown that the output unit 106 of the focus detection pixel 11R is provided at a region of the first focus detection pixel 11 at which the reflective unit 42A is not present (i.e. at a region more toward the +X axis direction than a line CL). But it would also be acceptable for the output unit 106 of the focus detection pixel 11R to be provided at a region of the focus detection pixel 11R at which the reflective unit 42A is present (i.e. at a region more toward the -X axis direction than a line CL).

Fig. 4(c) is an enlarged sectional view of the focus detection pixel 11L of Fig. 3. In the following explanation, to structures that are similar to structures of the focus detection pixel 11R of Fig. 4(b), the same reference symbols are appended, and explanation thereof will be curtailed. This focus detection pixel 11L has a reflective unit 42B that is provided in a different position from that of the reflective unit 42A of the focus detection pixel 11R of Fig. 4(b). The reflective unit 42B covers almost half of the lower surface of the photoelectric conversion unit 41 (its portion more toward the right side (in the +X axis direction) than a line CL). Due to the provision of this reflective unit 42B, in the right side half of the photoelectric conversion unit 41, the light proceeding in the downward direction (i.e. in the -Z axis direction) through the photoelectric conversion unit 41 and that has passed through the photoelectric conversion unit 41 is reflected by the reflective unit 42B, and is again incident upon the photoelectric conversion unit 41 for a second time. Since this light that is again incident upon the photoelectric conversion unit 41 is photoelectrically converted thereby, accordingly the amount of electric charge that is generated by the photoelectric conversion unit 41 is increased, as compared to the case of an imaging pixel 12 to which no reflective unit 42B is provided.

In other words, as will be explained hereinafter in detail, in the focus detection pixel 11L, along with first and second ray bundles that have passed through the first and second regions of the pupil of the imaging optical system 31 being incident upon the photoelectric conversion unit 41, also, among the light that has passed through the photoelectric conversion unit 41, this first ray bundle that has passed through the first region is reflected by the reflective unit 42B, and is again incident upon the photoelectric conversion unit 41 for a second time.

As has been described above, with the focus detection pixels 11R, 11L, among the first and second ray bundles that have passed through the first and second regions of the pupil of the imaging optical system 31, for example the first ray bundle is reflected by the reflective unit 42B of the focus detection pixel 11L, while for example the second ray bundle is reflected by the reflective unit 42A of the focus detection pixel 11R.

In relation to the micro lens 40 of the focus detection pixel 11L, the optical power of the micro lens 40 is determined so that the position of the reflective unit 42B that is provided on the lower surface of the photoelectric conversion unit 41 is conjugate to the position of the pupil of the imaging optical system 31 (in other words, to the exit pupil 60 that will be explained hereinafter).

Due to the provision of the structure described above, incidence of the first and second ray bundles upon regions other than the photoelectric conversion unit 41, and leakage thereof to neighboring pixels, are prevented, so that the amount of light incident upon the photoelectric conversion unit 41 is increased. To put this in another manner, the amount of electric charge generated by the photoelectric conversion unit 41 is increased.

In the focus detection pixel 11L, in a similar manner to the case with the focus detection pixel 11R, it would also be acceptable for a part of the wiring 108 formed in the wiring layer 107, for example a part of a signal line connected to the output unit 106, to be also employed as the reflective unit 42B. In this case, the reflective unit 42B would serve both as a reflective layer that reflects light that has passed through the photoelectric conversion unit 41 and is proceeding in the direction downward from the photoelectric conversion unit 41 (i.e. in the -Z axis direction), and also as a signal line that transmits a signal.

Furthermore, in the focus detection pixel 11L, it would also be acceptable for a part of the insulation layer used in the wiring layer 107 to be also employed as the reflective unit 42B. In this case, the reflective unit 42B would serve both as a reflective layer that reflects light that has passed through the photoelectric conversion unit 41 and is proceeding in the direction downward from the photoelectric conversion unit 41 (i.e. in the -Z axis direction), and also as an insulation layer.

In a similar manner to the case with the focus detection pixel 11R, the signal of the focus detection pixel 11L that has been outputted from the output unit 106 to the wiring layer 107 is subjected to signal processing such as, for example, A/D conversion and so on by peripheral circuitry not shown in the figures provided on the second substrate 114, and is then read out by the body control unit 21 (refer to Fig. 1).

It should be understood that, in a similar manner to the case with the focus detection pixel 11R, it will be acceptable for the output unit 106 of the focus detection pixel 11L to be provided at a region at which the reflective unit 42B is not present (i.e. at a region more toward the -X axis direction than a line CL), or, alternatively, it would also be acceptable for the output unit to be provided at a region at which the reflective unit 42B is present (i.e. at a region more toward the +X axis direction than a line CL).

Generally, with a semiconductor substrate such as a silicon substrate or the like, the transmittance exhibits different characteristics according to the wavelength of the incident light. The transmittance through the silicon substrate is generally higher for light of long wavelength than for light of short wavelength. For example, among the light that has been photoelectrically converted by an image sensor 22, the red color light whose wavelength is longer passes more easily through the semiconductor layer 105 (i.e. through the photoelectric conversion unit 41) as compared to the light of the other colors (i.e. of green color and of blue color).

In this embodiment, the focus detection pixels 11R, 11L are disposed in positions for R pixels, since the transmittance of the red color light is higher. When the light that proceeds through the photoelectric conversion units 41 in the downward direction (i.e. in the -Z axis direction) is red color light, it can easily pass through the photoelectric conversion units 41 and arrive at the reflective units 42A, 42B. Due to this, it is possible for the red color light that has passed through the photoelectric conversion units 41 to be reflected back by the reflective units 42A, 42B, and to be again incident upon the photoelectric conversion units 41 for a second time. As a result, the amounts of electric charge that are generated by the photoelectric conversion units 41 in the focus detection pixels 11R, 11L are increased. In this manner, the focus detection pixels 11R, 11L may be said to be focus detection pixels suitable for the long wavelength range (in this example, for red color) among the wavelength ranges of the light that is photographically converted by the image sensor 22.

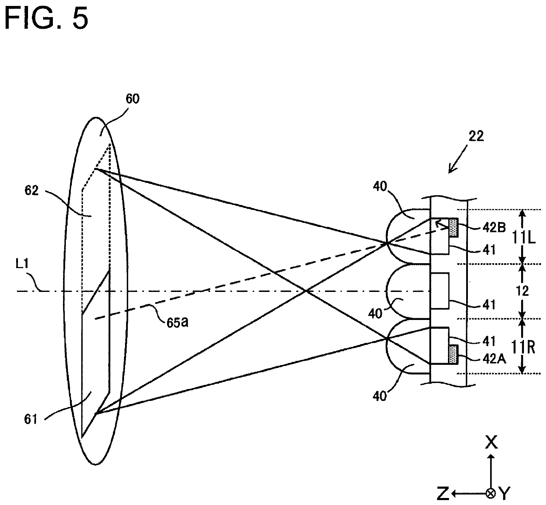

Fig. 5 is a figure for explanation of ray bundles that are incident upon the focus detection pixels 11R, 11L. An individual unit consisting of the focus detection pixels 11R, 11L described above and an imaging pixel 12 sandwiched between them is shown in the figure.

First, directing attention to the focus detection pixel 11L of Fig. 5, a first ray bundle that has passed through a first pupil region 61 of the exit pupil 60 of the imaging optical system of Fig. 1 and a second ray bundle that has passed through a second pupil region 62 thereof are incident via the micro lens 40 upon the photoelectric conversion unit 41. Moreover, among the first and second ray bundles incident upon the photoelectric conversion unit 41, the first ray bundle passes through the photoelectric conversion unit 41 and is reflected by the reflective unit 42B, and is again incident upon the photoelectric conversion unit 41 for a second time. In this manner, the focus detection pixel 11L outputs a signal (S1+S3) that is obtained by adding a signal S1 based upon the electric charges resulting from photoelectric conversion of both the first and second ray bundles that have respectively passed through the first pupil region 61 and the second pupil region 62 and are incident upon the photoelectric conversion unit 41, to a signal S3 based upon the electric charge resulting from photoelectric conversion of the first ray bundle that is reflected by the reflective unit 42B and is again incident upon the photoelectric conversion unit 41.

It should be understood that, in Fig. 5, the first ray bundle that passes through the first pupil region 61 and then passes through the micro lens 40 of the focus detection pixel 11L and through its photoelectric conversion unit 41, and is reflected back by its reflective unit 42B and is again incident upon the photoelectric conversion unit 41, is schematically shown by a broken line 65a.

On the other hand, directing attention to the focus detection pixel 11R of Fig. 5, a first ray bundle that has passed through the first pupil region 61 of the exit pupil 60 of the imaging optical system 31 of Fig. 1 and a second ray bundle that has passed through a second pupil region 62 thereof are incident via the micro lens 40 upon the photoelectric conversion unit 41. Moreover, among the first and second ray bundles incident upon the photoelectric conversion unit 41, the second ray bundle passes through the photoelectric conversion unit 41 and is reflected by the reflective unit 42A, to be again incident upon the photoelectric conversion unit 41 for a second time. In this manner, the focus detection pixel 11R outputs a signal (S1+S2) that is obtained by adding a signal S1 based upon the electric charges resulting from photoelectric conversion of both the first and second ray bundles that have respectively passed through the first pupil region 61 and the second pupil region 62 and are incident upon the photoelectric conversion unit 41, to a signal S2 based upon the electric charge resulting from photoelectric conversion of the second ray bundle that is reflected by the reflective unit 42A and is again incident upon the photoelectric conversion unit 41.

Next, directing attention to the imaging pixel 12 of Fig. 5, ray bundles that have passed through both the first pupil region 61 and the second pupil region 62 of the exit pupil 60 of the imaging optical system of Fig. 1 are incident via its micro lens 40 upon its photoelectric conversion unit 41. In this manner, the imaging pixel 12 outputs a signal S1 based upon the electric charges resulting from photoelectric conversion of both the ray bundles that have respectively passed through the first pupil region 61 and the second pupil region 62 and are incident upon the photoelectric conversion unit 41.

### Generation of the Image Data

The image generation unit 21b of the body control unit 21 generates image data related to the photographic subject image on the basis of the signals S1 from the imaging pixels 12, the signal (S1+S2) from the focus detection pixel 11R, and the signal (S1+S3) from the focus detection pixel 11L.

It should be understood that when generating this image data, in order to suppress negative influence of the signals S2 and S3, or, to put it in another manner, in order to suppress negative influence due to the difference between the amount of electric charge generated by the photoelectric conversion unit 41 of the imaging pixel 12 and the amounts of electric charge generated by the photoelectric conversion units 41 of the focus detection pixels 11L, 11R, it will be acceptable to provide a difference between a gain applied to the signal S1 from the imaging pixel 12 and gains applied to the respective signals (S1+S2), (S1+S3) from the focus detection pixels 11R, 11L. For example, the gains applied to the respective signals (S1+S2), (S1+S3) of the focus detection pixels 11R, 11L may be made to be smaller, as compared to the gain applied to the signal S1 of the imaging pixel 12.

### Detection of the Amount of Image Deviation

The focus detection unit 21a of the body control unit 21 detects an amount of image deviation in the following manner, on the basis of the signal S1 from the imaging pixel 12, the signal (S1+S2) from the focus detection pixel 11R, and the signal (S1+S3) from the focus detection pixel 11L. That is, the focus detection unit 21a obtains the difference diff2 between the signal S1 from the imaging pixel 12 and the signal (S1+S2) from the focus detection pixel 11R, and also obtains the difference diff3 between the signal S1 from the imaging pixel 12 and the signal (S1+S3) from the focus detection pixel 11L. The difference diff2 corresponds to the signal S2 based upon the electric charge obtained by photoelectric conversion of the second ray bundle that was reflected by the reflective unit 42A of the focus detection pixel 11R. In a similar manner, the difference diff3 corresponds to the signal S3 based upon the electric charge obtained by photoelectric conversion of the first ray bundle that was reflected by the reflective unit 42B of the focus detection pixel 11L.

On the basis of these differences diff3 and diff2 that have thus been obtained, the focus detection unit 21a obtains the amount of image deviation between the image due to the first ray bundle that has passed through the first pupil region 61, and the image due to the second ray bundle that has passed through the second pupil region 62. In other words, by collecting together the group of differences diff3 of signals obtained from each of the plurality of units described above, and the group of differences diff2 of signals obtained from each of the plurality of units described above, the focus detection unit 21a is able to obtain information representing the intensity distributions of a plurality of images formed by a plurality of focus detection ray bundles that have passed through the first pupil region 61 and the second pupil region 62 respectively.

The focus detection unit 21a calculates the amounts of image deviation of the plurality of images by performing image deviation detection calculation processing (i.e. correlation calculation processing and phase difference calculation processing) upon the intensity distributions of the plurality of images described above. Moreover, the focus detection unit 21a also calculates a defocusing amount by multiplying this amount of image deviation by a predetermined conversion coefficient. This type of defocusing amount calculation according to a split pupil type phase difference focus detection method is per se known, and therefore detailed explanation thereof will be omitted.

### The Circuit Structure

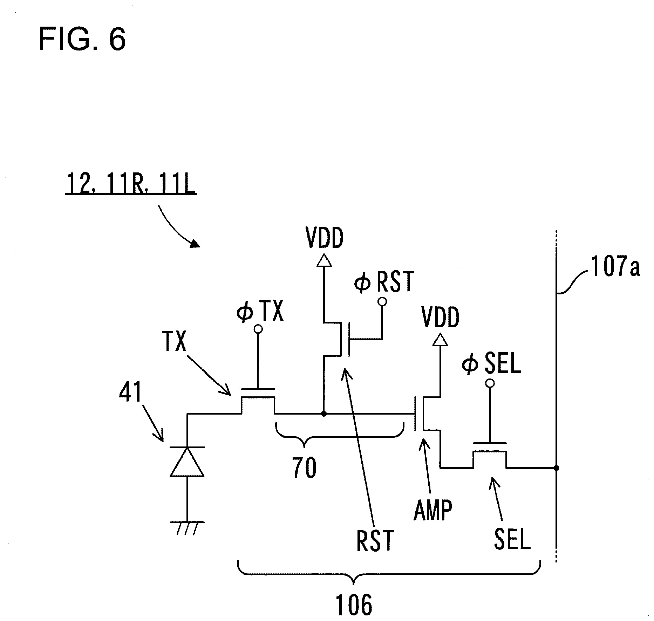

Fig. 6 is a figure showing the circuit structure of a single imaging pixel 12. It should be understood that the circuit structure of the focus detection pixels 11R, 11L is the same as the circuit structure of the imaging pixel 12 shown in Fig. 6, and accordingly explanation thereof will be curtailed.

The output unit 106 includes a transfer transistor TX, a reset transistor RST, an amplification transistor AMP, and a selection transistor SEL. A transfer signal ϕTX is supplied to the gate electrode of the transfer transistor TX. The transfer transistor TX is turned on and off by this transfer signal ϕTX.

When the transfer transistor TX is turned on by the transfer signal ϕTX, the transfer transistor TX transfers the electric charge that has been photoelectrically converted by the photoelectric conversion unit 41 of the imaging pixel 12 to an accumulation unit 70. The accumulation unit 70 is a so-called floating diffusion. And the amplification transistor AMP outputs to the selection transistor SEL a signal whose magnitude corresponds to the amount of electric charge accumulated in the accumulation unit 70.

A selection signal ϕSEL is supplied to the gate electrode of the selection transistor SEL. The selection transistor SEL is turned on and off by this selection signal ϕSEL. When the selection transistor SEL is turned on by the selection signal ϕSEL, the selection transistor SEL outputs the signal outputted by the amplification transistor AMP to a vertical signal line 107a.

A reset signal ϕRST is supplied to the gate electrode of the reset transistor RST. The reset transistor RST is turned on and off by this reset signal ϕRST. When the reset transistor RST is turned on by the reset signal ϕRST, the reset transistor RST resets the electric charge accumulated in the accumulation unit 70. In other words, the reset transistor RST discharges the accumulated electric charge from the accumulation unit 70.

### The Circuit Layout

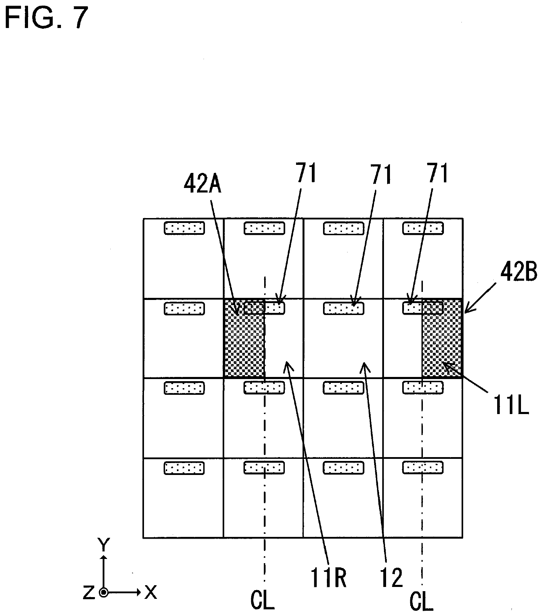

Fig. 7 is a plan view, schematically showing the circuit layout of a number of imaging pixels 12 and focus detection pixels 11R, 11L. Of the plurality of pixels that are arranged in the region 22a of the image sensor 22 that generates an image (refer to Fig. 3), Fig. 7 only shows a total of sixteen pixels arranged in a four row by four column array. In Fig. 7, each single pixel is shown by a white square surrounded by a black line. As explained in connection with Fig. 3, focus detection pixels 11R, 11L are disposed at positions where otherwise R pixels would be located.

The gate electrodes 71 of the transfer transistors TX of the imaging pixels 12 and the focus detection pixels 11R, 11L have rectangular shapes that extend wider in the horizontal direction on the drawing paper (i.e. in the X axis direction). Each of the gate electrodes 71 is disposed closer to the upper side on the drawing paper (i.e. more toward the +Y axis direction) than the center of its photoelectric conversion unit 41. In other words, in a plane that intersects the direction in which light is incident (i.e. the -Z axis direction) and is parallel to the direction of arrangement of the focus detection pixels 11R, 11L (i.e. the +X axis direction), the gate electrodes 71 are provided more toward a direction that intersects the direction of arrangement (i.e. toward the +Y axis direction) than the centers of the photoelectric conversion units 41.

In the entire focus detection pixel 11R, its reflective unit 42A is provided at a position corresponding to its left half. And, in the entire focus detection pixel 11L, its reflective unit 42B is provided at a position corresponding to its right half. In other words, in a plane that intersects the direction in which light is incident (i.e. the -Z axis direction), the reflective unit 42B is provided in a region that is more toward the direction in which the focus detection pixels 11R, 11L are arranged (i.e. the +X axis direction) than the center of the photoelectric conversion unit 41 of the focus detection pixel 11L. In a similar manner, in a plane that intersects the direction in which light is incident (i.e. the -Z axis direction), the reflective unit 42A is provided in a region that is more toward the direction (i.e. the -X axis direction) that is opposite to the direction in which the focus detection pixels 11R, 11L are arranged (i.e. the +X axis direction) than the center of the photoelectric conversion unit 41 of the focus detection pixel 11R.

To put it in another manner, in a plane that intersects the direction in which light is incident (i.e. the -Z axis direction), the reflective unit 42B is provided in a region that, among the regions subdivided by a line CL parallel to a line passing through the center of the photoelectric conversion unit 41 of the focus detection pixel 11L, is more toward the direction in which the focus detection pixels 11R, 11L are arranged (i.e. the +X axis direction). In a similar manner, in a plane that intersects the direction in which light is incident (i.e. the -Z axis direction), the reflective unit 42A is provided in a region that, among the regions subdivided by a line CL parallel to a line passing through the center of the photoelectric conversion unit 41 of the focus detection pixel 11R, is more toward the direction (i.e. toward the -X axis direction) that is opposite to the direction in which the focus detection pixels 11R, 11L are arranged (i.e. the +X axis direction).

In other words, in a plane that intersects the direction in which light is incident (i.e. the -Z axis direction) and that is parallel to the direction in which the focus detection pixels 11R, 11L are arranged (i.e. the +X axis direction), the reflective unit 42B is provided in a region that, among the regions subdivided by a line CL parallel to a line passing through the center of the photoelectric conversion unit 41 of the focus detection pixel 11L, is more toward the direction in which the focus detection pixels 11R, 11L are arranged (i.e. the +X axis direction). In a similar manner, in a plane that intersects the direction in which light is incident (i.e. the -Z axis direction) and that is parallel to the direction in which the focus detection pixels 11R, 11L are arranged (i.e. the +X axis direction), the reflective unit 42A is provided in a region that, among the regions subdivided by a line CL parallel to a line passing through the center of the photoelectric conversion unit 41 of the focus detection pixel 11R, is more toward the direction (i.e. toward the -X axis direction) that is opposite to the direction in which the focus detection pixels 11R, 11L are arranged (i.e. the +X axis direction).

To put it in another manner, in a plane that intersects the direction in which light is incident (i.e. the -Z axis direction) and that is parallel to the direction in which the focus detection pixels 11R, 11L are arranged (i.e. the +X axis direction), the reflective unit 42B is provided in a region that, among the regions subdivided by a line CL orthogonal to a line passing through the center of the photoelectric conversion unit 41 of the focus detection pixel 11L and orthogonal to that plane, is more toward the direction in which the focus detection pixels 11R, 11L are arranged (i.e. the +X axis direction). In a similar manner, in a plane that intersects the direction in which light is incident (i.e. the -Z axis direction) and that is parallel to the direction in which the focus detection pixels 11R, 11L are arranged (i.e. the +X axis direction), the reflective unit 42A is provided in a region that, among the regions subdivided by a line CL orthogonal to a line passing through the center of the photoelectric conversion unit 41 of the focus detection pixel 11R and orthogonal to that plane, is more toward the direction (i.e. toward the -X axis direction) that is opposite to the direction in which the focus detection pixels 11R, 11L are arranged (i.e. the +X axis direction).

In the plan view of Fig. 7, parts of the gate electrodes 71 of the transfer transistors TX of the focus detection pixels 11R, 11L overlap the respective reflective units 42A, 42B. This implies that parts of the gate electrodes 71 are provided upon the optical paths along which light that has passed through the photoelectric conversion units 41 of the focus detection pixels 11R, 11L is incident upon the reflective units 42A, 42B.

As described above, the light that has passed through the photoelectric conversion units 41 is directed toward the reflective units 42A, 42B. It is preferred for no other members to be disposed upon these light paths. From the standpoint of convenience of the pixel structure shown by way of example in Fig. 4, some members, such as for example the gate electrodes 71 of the transfer transistors 71 or the like, need to be disposed upon these optical paths of this light. When some of the incident light is reflected or absorbed by a member such as a gate electrode 71 or the like, the amount of electric charge generated by the corresponding photoelectric conversion unit 41 changes. Due to this, if the arrangements of the gate electrodes 71 or the like are different between the focus detection pixel 11R and the focus detection pixel 11L, then the photoelectric conversion signals are not balanced (i.e. the symmetry of the photoelectric conversion signals is destroyed), and the accuracy of calculation of the amount of defocusing will undesirably decrease. But, in this embodiment, the arrangement of the members upon the optical paths of incident light, such as the gate electrodes 71 and the like, is aligned between the focus detection pixel 11R and the focus detection pixel 11L. In specific terms, the gate electrode 71 and the reflective unit 42A of the focus detection pixel 11L and the gate electrode 71 and the reflective unit 42B of the focus detection pixel 11R are arranged symmetrically left and right (i.e. in a bilaterally symmetric configuration with respect to the direction of arrangement of the pixel row 401). For example, the shapes, areas, and positions of the gate electrodes 71, the shapes, areas, and positions of the reflective unit 42A and the reflective unit 42B, the areas and positions where the reflective units 42A, 42B overlap with the corresponding gate electrodes 41, and so on, are arranged so as to be aligned. Due to this, the incident light is reflected and photoelectrically converted in a similar manner in the focus detection pixel 11R and in the focus detection pixel 11L, so that the signals that are outputted are balanced.

According to the first embodiment as described above, the following beneficial operational effects are obtained.
(1) Among the plurality of pixels that are arranged along the +X axis direction, each of the focus detection pixels 11R, 11L includes a photoelectric conversion unit 41 that photoelectrically converts incident light and generates electric charge, a reflective unit 42A or 42B that reflects light passing through the photoelectric conversion unit 41 back to the photoelectric conversion unit 41, and an output unit 106 that outputs electric charge generated by photoelectric conversion by the photoelectric conversion unit 41. In a plane intersecting the direction in which light is incident, the reflective unit 42B of the focus detection pixel 11L is provided in a region more toward the +X axis direction than the center of the photoelectric conversion unit 41 of the focus detection pixel 11L. And, in a plane intersecting the direction in which light is incident, the reflective unit 42A of the focus detection pixel 11R is provided in a region more toward the direction opposite to the +X axis direction than the center of the photoelectric conversion unit 41 of the focus detection pixel 11R.The gate electrode 71 of the transfer transistor TX, which is one portion of the output unit 106 of the focus detection pixel 11L, is provided upon the optical path along which light that has passed through the photoelectric conversion unit 41 of the focus detection pixel 11L is incident upon the reflective unit 42B of the focus detection pixel 11L. And the gate electrode 71 of the transfer transistor TX, which is one portion of the output unit 106 of the focus detection pixel 11R, is provided upon the optical path along which light that has passed through the photoelectric conversion unit 41 of the focus detection pixel 11R is incident upon the reflective unit 42A of the focus detection pixel 11R. Since this structure is adopted, it is possible to perform focus detection at high accuracy, without experiencing any negative influence due to light that has been refracted, light that has been reflected, or light that has been absorbed striking the electrodes or the like.
(2) In a plane intersecting the direction in which light is incident, the reflective unit 42B of the focus detection pixel 11L is provided, among regions subdivided by a line CL parallel to a line passing through the center of the photoelectric conversion unit 41 of the focus detection pixel 11L, in a region toward the +X axis direction. And, in a plane intersecting the direction in which light is incident, the reflective unit 42A of the focus detection pixel 11R is provided, among regions subdivided by a line CL parallel to a line passing through the center of the photoelectric conversion unit 41 of the focus detection pixel 11R, in a region toward the direction opposite to the +X axis direction. Since this structure is adopted, accordingly the symmetry of the electrodes and so on is preserved more precisely, so that it is possible to perform focus detection at higher accuracy.
(3) In a plane intersecting the direction in which light is incident and parallel to the +X axis direction, the reflective unit 42B of the focus detection pixel 11L is provided, among regions subdivided by a line CL parallel to a line passing through the center of the photoelectric conversion unit 41 of the focus detection pixel 11L, in a region toward the +X axis direction. And, in a plane intersecting the direction in which light is incident and parallel to the +X axis direction, the reflective unit 42A of the focus detection pixel 11R is provided, among regions subdivided by a line CL parallel to a line passing through the center of the photoelectric conversion unit 41 of the focus detection pixel 11R, in a region toward the direction opposite to the +X axis direction. Since this structure is adopted, accordingly the symmetry of the electrodes and so on is preserved more precisely, so that it is possible to perform focus detection at higher accuracy.
(4) In a plane intersecting the direction in which light is incident and parallel to the +X axis direction, the reflective unit 42B of the focus detection pixel 11L is provided, among regions subdivided by a line CL orthogonal to a line passing through the center of the photoelectric conversion unit 41 of the focus detection pixel 11L and orthogonal to that plane, in a region toward the +X axis direction. And, in a plane intersecting the direction in which light is incident and parallel to the +X axis direction, the reflective unit 42A of the focus detection pixel 11R is provided, among regions subdivided by a line CL orthogonal to a line passing through the center of the photoelectric conversion unit 41 of the focus detection pixel 11R and orthogonal to that plane, in a region toward the direction opposite to the +X axis direction. Since this structure is adopted, accordingly the symmetry of the electrodes and so on is preserved more precisely, so that it is possible to perform focus detection at higher accuracy.
(5) In a plane intersecting the direction in which light is incident and parallel to the +X axis direction, the output unit 106 of the focus detection pixel 11L is provided more toward the +Y axis direction that intersects the +X axis direction than the center of the photoelectric conversion unit 41 of the focus detection pixel 11L. And, in a plane intersecting the direction in which light is incident and parallel to the +X axis direction, the output unit 106 of the focus detection pixel 11R is provided more toward the +Y axis direction that intersects the +X axis direction than the center of the photoelectric conversion unit 41 of the focus detection pixel 11R. Since this structure is adopted, accordingly the symmetry of the electrodes and so on is preserved more precisely, so that it is possible to perform focus detection at higher accuracy.
(6) The output unit 106 of the focus detection pixel 11L and the output unit 106 of the focus detection pixel 11R are configured so that the areas they occupy upon planes that intersect the directions of light incidence are the same. Since these arrangements are adopted, it is possible to perform focus detection at yet higher accuracy, because the symmetry of the electrodes and so on is more precisely preserved.
(7) The focus detection pixel 11L has a color filter that passes a specific wavelength range. Moreover, the focus detection pixel 11R has a color filter that passes the same specific wavelength range. Since this configuration is adopted, it is possible to perform focus detection at high accuracy, even if the incident light is biased for some wavelength range.
(8) The image sensor 22 has the pixel column 401S in which the focus detection pixel 11L and the focus detection pixel 11R are provided along the X axis direction. Since this configuration is adopted, accordingly it is possible to perform focus detection at high accuracy.
(9) The photoelectric conversion unit 41 generates electric charge by photoelectrically converting incident light. And the reflective units 42A, 42B reflect light that has passed through the photoelectric conversion units 41 back to the photoelectric conversion units 41. The output units 106 output electric charges generated by photoelectric conversion by the photoelectric conversion units 41. And the gate electrodes 71 of the transfer transistors TX, which are parts of the output units 106, are provided upon the optical paths along which light that has passed through the photoelectric conversion units 41 is incident upon the reflective units 42A, 42B. Since these arrangements are adopted, it is still possible to perform focus detection at high accuracy, even though part or all of the output units are disposed upon the optical paths of incident light.
(10) The output unit 106 includes the transfer transistor TX that transfers electric charge generated by the photoelectric conversion unit 41 to the accumulation unit 70 that accumulates electric charge. Since this configuration is adopted, it is still possible to perform focus detection at high accuracy, even though part or all of the transfer transistor is disposed upon the optical path of incident light.
(11) The output unit 106 includes the gate electrode 71 of the transfer transistor TX. Since this configuration is adopted, it is still possible to perform focus detection at high accuracy, even though the gate electrode of the transfer transistor is disposed upon the optical path of incident light.
(12) The body control unit 21 adjusts the focusing position of the imaging optical system 31 on the basis of the electric charges outputted from the output units 106. Since this is done, it is possible to implement automatic focus adjustment control at high accuracy.

### Second Embodiment

A second embodiment will now be explained, with attention being principally concentrated upon the features of difference from the first embodiment.

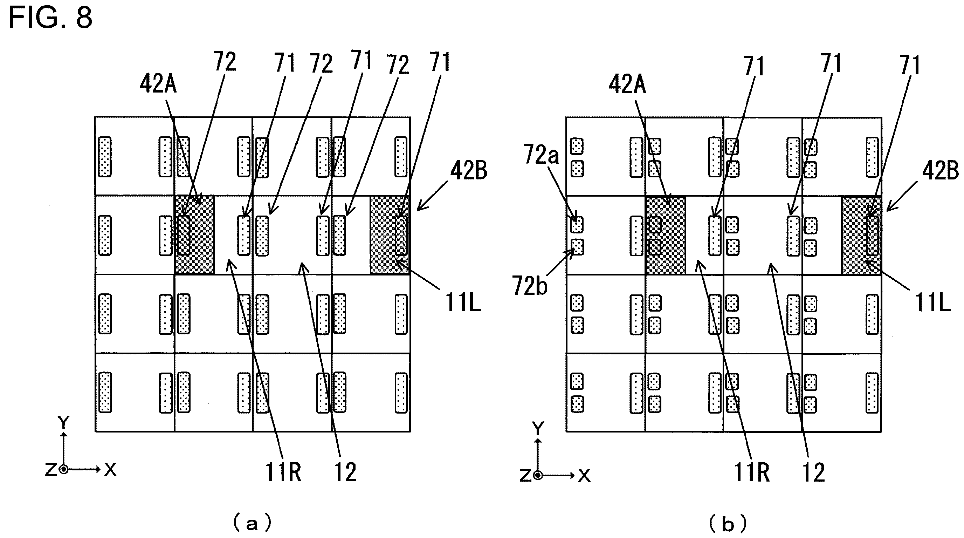

Fig. 8(a) is a plan view, schematically showing the circuit layout of a number of imaging pixels 12 and focus detection pixels 11R, 11L. Of the plurality of pixels that are arranged in the region 22a of the image sensor 22 that generates an image (refer to Fig. 3), Fig. 8(a) only shows a total of sixteen pixels arranged in a four row by four column array.

The gate electrodes 71 of the transfer transistors TX included in the imaging pixels 12 and in the focus detection pixels 11R, 11L have the shapes of rectangles that extend taller in the vertical direction on the drawing paper (i.e. in the Y axis direction). The gate electrodes 71 are disposed more toward the rightward direction on the drawing paper (i.e. toward the +X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward that direction of arrangement (i.e. toward the +X axis direction) than the centers of the corresponding photoelectric conversion units 41.

The gate electrodes 72 of the reset transistors RST of the imaging pixels 12 and the focus detection pixels 11R, 11L have almost the same shapes as the gate electrodes 71 of the transfer transistors TX. That is, the gate electrodes 72 of the reset transistors RST have rectangular shapes that extend taller in the vertical direction on the drawing paper (i.e. in the Y axis direction). These gate electrodes 72 are disposed more toward the leftward direction on the drawing paper (i.e. toward the -X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 72 are provided more toward the direction opposite to that direction of arrangement (the +X axis direction) than the centers of the corresponding photoelectric conversion units 41.

As described above, in this embodiment, in addition to the gate electrodes 71 of the transfer transistors TX, the gate electrodes 72 of the reset transistors RST are also disposed upon the optical paths. The gate electrodes 71 of the transfer transistors TX and the gate electrodes 72 of the reset transistors RST have shapes and areas that are almost the same, and they are arranged symmetrically with respect to the left and right edges of the pixels. In the focus detection pixel 11L, the gate electrode 71 of the transfer transistor TX is disposed upon the optical path of the light that is incident upon the reflective unit 42B. And, in the focus detection pixel 11R, the gate electrode 72 of the reset transistor RST is disposed in a position corresponding thereto. Since the gate electrode 71 of the transfer transistor TX and the gate electrode 72 of the reset transistor RST are arranged symmetrically in this manner, accordingly similar beneficial effects to those obtained with the first embodiment can be obtained. That is, the incident light is reflected and photoelectrically converted in a similar manner in the focus detection pixel 11R and in the focus detection pixel 11L, so that balanced signals are outputted.

It should be understood that although, in the above explanation, an example has been described in which, in addition to the gate electrodes 71 of the transfer transistors TX, the gate electrodes 72 of the reset transistors RST are also arranged upon the optical paths, it would also be acceptable to arrange for some other members in the output units 106, or dummy electrodes or the like, to be arranged in that manner, instead of the gate electrodes 72 of the reset transistors RST. For example, it would be possible for electrodes of the selection transistors SEL or electrodes of the amplification transistors AMP to be arranged in that manner, or for dummy electrodes that are provided only with the objective of preserving the symmetry of the signals to be disposed in that manner.

Furthermore, as shown by way of example in Fig. 8(b), it would also be possible to arrange for two electrodes 72a, 72b to be provided to correspond to a single electrode 72. In other words, it would be acceptable to arrange for a plurality of electrodes or the like to be disposed in similar positions to those of the gate electrodes of the reset transistors RST shown as examples in Fig. 8(a), so as to have similar external shapes and to occupy similar areas. In Fig. 8(b), for example, one of the two electrodes 72a, 72b is a gate electrode of a reset transistor RST, while the other is a gate electrode of a selection transistor SEL. Each of the two electrodes 72a, 72b has a shape that is obtained by halving the gate electrode 72 of the reset transistor RST shown in Fig. 8(a). In Fig. 8(b), those two electrodes 72a, 72b are disposed in the position where the gate electrode 72 of the reset transistor RST was disposed in Fig. 8(a).

According to the embodiment described above, in addition to the beneficial operational effects obtained with the first embodiment, the following further beneficial operational effects are also obtained.
(13) In a plane that intersects the direction in which light is incident and that is parallel to the +X axis direction, the output unit 106 of the focus detection pixel 11L is provided more toward the +X axis direction than the center of the photoelectric conversion unit 41 of the focus detection pixel 11L, and, in a plane that intersects the direction in which light is incident and that is parallel to the +X axis direction, the output unit 106 of the focus detection pixel 11R is provided more toward the direction opposite to the +X axis direction than the center of the photoelectric conversion unit 41 of the focus detection pixel 11R. Due to this, it is possible to perform focus detection at high accuracy even when part or all of the output unit is disposed upon the optical path along which light is incident.
(14) In the focus detection pixel 11L, the electrode of the transfer transistor TX that transfers electric charge generated by the photoelectric conversion unit 41 to the accumulation unit 70 is provided upon the optical path along which light that has passed through the photoelectric conversion unit 41 is incident upon the reflective unit 42B. And, in the focus detection pixel 11R, the electrode of the reset transistor RST that discharges electric charge generated by the photoelectric conversion unit 41 is provided upon the optical path along which light that has passed through the photoelectric conversion unit 41 is incident upon the reflective unit 42A. Due to this, it is possible to perform focus detection at high accuracy even when part or all of the reset transistor is disposed upon the optical path along which light is incident.

### Third Embodiment

A third embodiment will now be explained, with attention being principally concentrated upon the features of difference from the first embodiment.

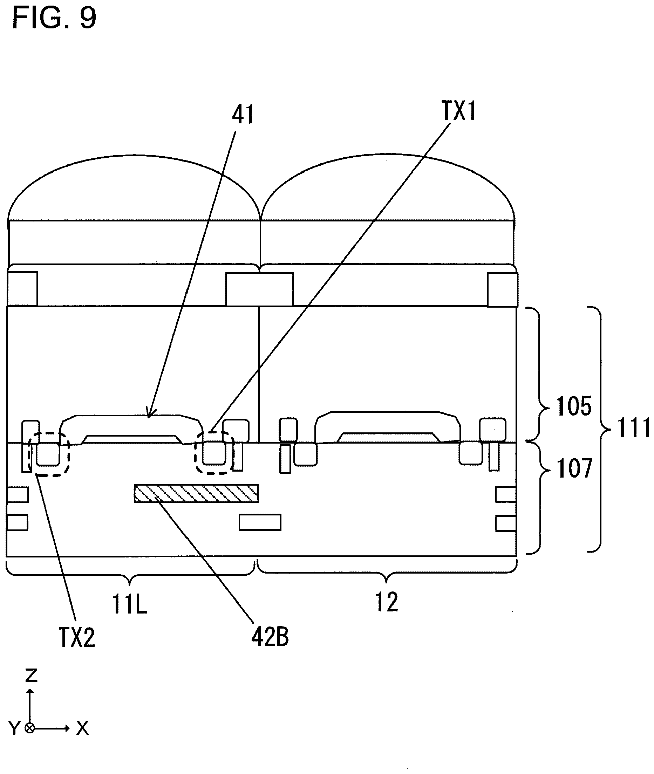

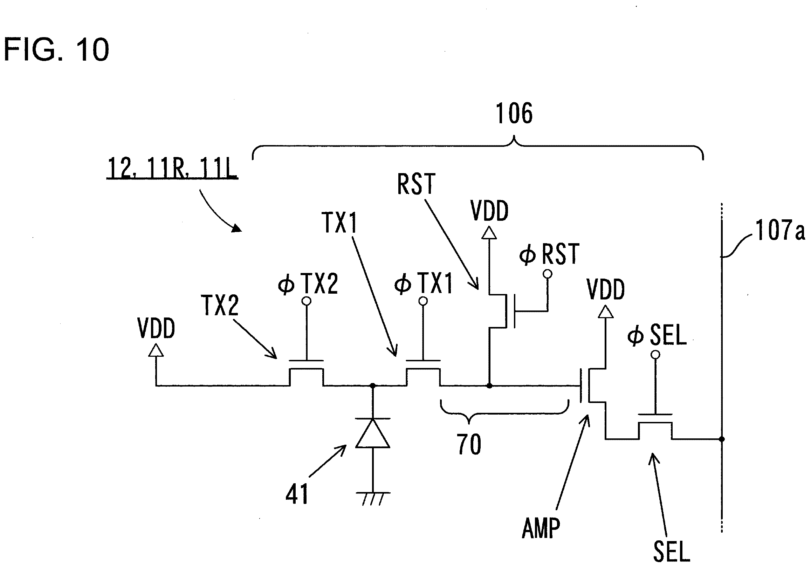

Fig. 9 is an enlarged sectional view showing an imaging pixel 12 and a focus detection pixel 11L, and Fig. 10 is a figure showing the circuit structure of this imaging pixel 12. It should be understood that, since the structure of the focus detection pixel 11R is the same as that of the focus detection pixel 11L, accordingly it is omitted from Fig. 9. Moreover, since the imaging pixel 12 and the focus detection pixels 11L, 11R all have similar circuit structures, accordingly only the circuit structure of the single imaging pixel 12 is shown in Fig. 10, as being representative.

In this embodiment, each of the output units 106 of the imaging pixel 12 and the focus detection pixel 11L has two transfer transistors TX1, TX2. The transfer transistor TX1 transfers electric charge photoelectrically converted by the photoelectric conversion unit 41 to the accumulation unit 70. And the transfer transistor TX2 resets the electric charge photoelectrically converted by the photoelectric conversion unit 41 (i.e. discharges that charge from the photoelectric conversion unit 41).

A transfer signal ϕTX1 is supplied to the gate electrode of the transfer transistor TX1. The transfer transistor TX1 is turned on and off by this transfer signal ϕTX1. And a transfer signal ϕTX2 is supplied to the gate electrode of the transfer transistor TX2. The transfer transistor TX2 is turned on and off by this transfer signal ϕTX2.

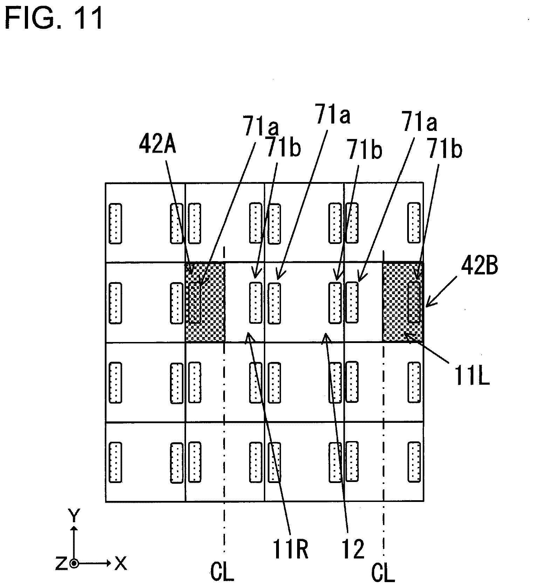

Fig. 11 is a plan view, schematically showing the circuit layout of a number of imaging pixels 12 and focus detection pixels 11R, 11L. Of the plurality of pixels that are arranged in the region 22a of the image sensor 22 that generates an image (refer to Fig. 3), Fig. 11 only shows a total of sixteen pixels arranged in a four row by four column array.

The gate electrodes 71b of the transfer transistors TX2 included in the imaging pixels 12 and in the focus detection pixels 11R, 11L have the shape of rectangles that extend taller in the vertical direction on the drawing paper (i.e. in the Y axis direction). The gate electrodes 71b are disposed more toward the rightward direction on the drawing paper (i.e. toward the +X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71b are provided more toward that direction of arrangement (i.e. toward the +X axis direction) than the centers of the corresponding photoelectric conversion units 41.

The gate electrodes 71a of the transfer transistors TX1 included in the imaging pixels 12 and the focus detection pixels 11R, 11L have the shape of rectangles that are almost the same shapes as the gate electrodes 71b of the transfer transistors TX2. In other words, the gate electrodes 71a of the transfer transistors TX1 have the shapes of rectangles that extend taller in the vertical direction on the drawing paper (i.e. in the Y axis direction). The gate electrodes 71 are disposed more toward the leftward direction on the drawing paper (i.e. toward the -X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71a are provided more toward a direction that is opposite to that direction of arrangement (i.e. to the +X axis direction) than the centers of the corresponding photoelectric conversion units 41.

As described above, in this embodiment, the gate electrodes 71a of the transfer transistors TX1 and the gate electrodes 71b of the transfer transistors TX2 are disposed upon the optical paths. Moreover, the gate electrodes 71a of the transfer transistors TX1 and the gate electrodes 71b of the transfer transistors TX2 have shapes and areas that are almost the same, and are arranged symmetrically with respect to the left and right edges of the pixels. In the focus detection pixel 11L, the gate electrode 71b of the transfer transistor TX2 is disposed upon the optical path of the light that is incident upon the reflective unit 42B. And, in the focus detection pixel 11R, the gate electrode 71a of the transfer transistor TX1 is disposed in a position corresponding thereto. Since the gate electrode 71a of the transfer transistor TX1 and the gate electrode 71b of the transfer transistor TX2 are arranged symmetrically in this manner, accordingly similar beneficial effects to those obtained with the first embodiment can be obtained. That is, the incident light is reflected and photoelectrically converted in a similar manner in the focus detection pixel 11R and in the focus detection pixel 11L, so that balanced signals are outputted.

Furthermore, in this embodiment, it is possible for resetting of the photoelectric conversion unit 41 to be performed by the transfer transistor TX2 without any influence being exerted upon the electric charge accumulated in the accumulation unit 70. Due to this, it is possible freely to control the exposure timing of the photoelectric conversion unit 41, after the electric charge has been temporarily transferred to the accumulation unit 70, and before the electric charge is read out from the accumulation unit 70. In other words, it is possible to set the start timing for the next exposure with no relationship to the timing of reading out the electric charge from the accumulation unit 70.

In this embodiment, in the focus detection pixel 11L, the electrodes of the transfer transistor TX2 that discharges the electric charge generated by the photoelectric conversion unit 41 from the photoelectric conversion unit 41 are provided upon the optical path along which light that has passed through the photoelectric conversion unit 41 is incident upon the reflective unit 42B. And, in the focus detection pixel 11R, the electrodes of the transfer transistor TX1 that transfers the electric charge to the accumulation unit 70 that accumulates the electric charge generated by the photoelectric conversion unit 41 are provided upon the optical path along which light that has passed through the photoelectric conversion unit 41 is incident upon the reflective unit 42A. Due to this, it is possible to perform focus detection at high accuracy, even when the additional transfer transistors TX2 are provided.

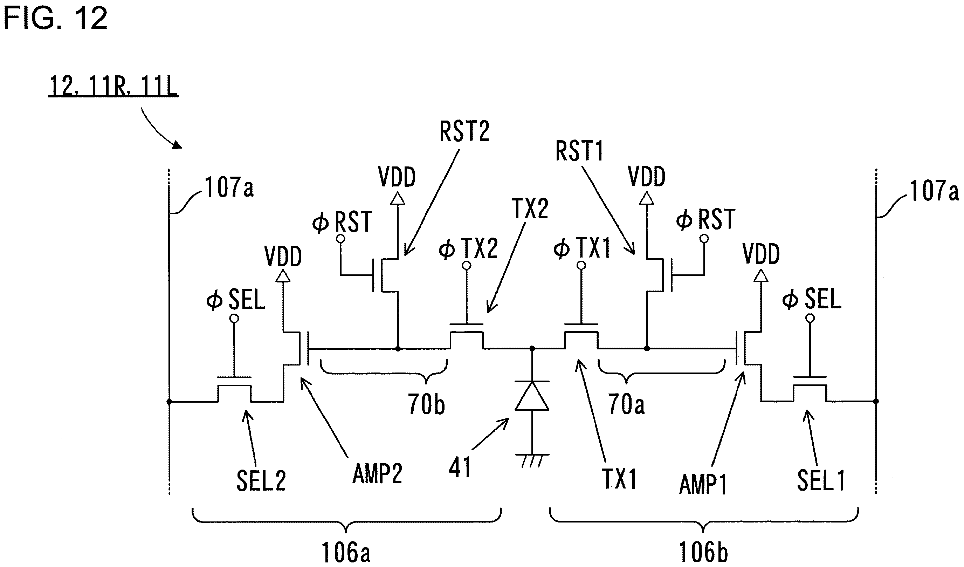

It should be understood that it would also be acceptable to arrange for the transfer transistor TX2 not to reset the electric charge accumulated in the photoelectric conversion unit 41, but to transfer the electric charge to a separate accumulation unit. An example of a circuit structure of this type is shown in Fig. 12. In Fig. 12, the pixel has two output units 106a, 106b. The output unit 106a comprises a transfer transistor TX1, an accumulation unit 70a, a reset transistor RST1, an amplification transistor AMP1, and a selection transistor SEL1. And the output unit 106b comprises a transfer transistor TX2, an accumulation unit 70b, a reset transistor RST2, an amplification transistor AMP2, and a selection transistor SEL2. When the pixel is structured in this manner, it is possible for the electric charge that has been photoelectrically converted by the photoelectric conversion unit 41 to be transferred to the accumulation unit 70a and the accumulation unit 70b in a time divided manner. For example, the exposure time period may be divided into two intervals, and the electric charge generated in the first interval may be transferred to the accumulation unit 70a, while the electric charge generated in the next interval may be transferred to the accumulation unit 70b. With this type of structure, it is possible to accumulate the electric charge into the two separated accumulation units, so that the dynamic range is enhanced. Moreover, since it is possible to perform two episodes of image capture whose exposure times are different in succession, accordingly it is possible to provide an image sensor that is appropriate for various photographic techniques, such as so-called auto bracketing photography or high dynamic range composition or the like.

### Fourth Embodiment

A fourth embodiment will now be explained, with attention being principally concentrated upon the features of difference from the first embodiment.

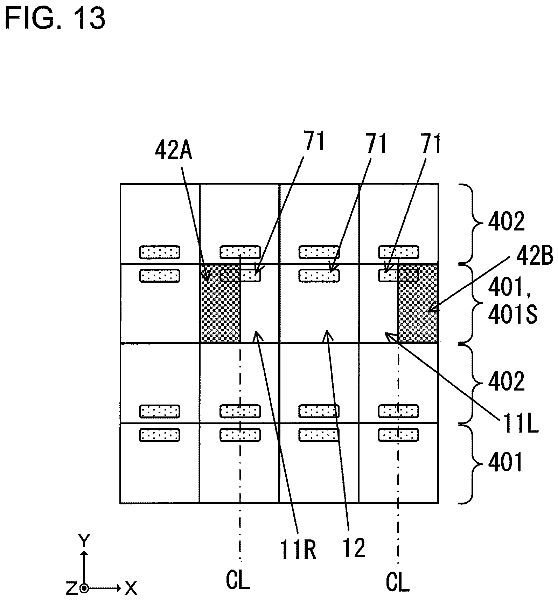

Fig. 13 is a plan view, schematically showing the circuit layout of a number of imaging pixels 12 and focus detection pixels 11R, 11L. Of the plurality of pixels that are arranged in the region 22a of the image sensor 22 that generates an image (refer to Fig. 3), Fig. 13 only shows a total of sixteen pixels arranged in a four row by four column array. In Fig. 13, each single pixel is shown by a white square surrounded by a black line. As explained in connection with Fig. 3, the focus detection pixels 11R, 11L are disposed at positions where otherwise R pixels would be located.

The gate electrodes 71 of the transfer transistors TX included in the imaging pixels 12 and the focus detection pixels 11R, 11L have the shape of rectangles that extend wider in the horizontal direction on the drawing paper (i.e. in the X axis direction). In the pixels arranged in the pixel rows 401, 401S, the gate electrodes 71 are disposed more toward the upward direction on the drawing paper (i.e. toward the +Y axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward a direction (i.e. toward the +Y axis direction) that intersects that direction of arrangement than the centers of the corresponding photoelectric conversion units 41.

In the imaging pixels 12 arranged in the pixel rows 402, the gate electrodes 71 are arranged more toward the downward direction upon the drawing paper (i.e. toward the -Y axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward a direction opposite to a direction (i.e. the +Y axis direction) that intersects that direction of arrangement than the centers of the corresponding photoelectric conversion units 41.

In other words, in this embodiment, the gate electrodes 71 of the transfer transistors TX of the pixels that are arranged in the pixel rows 402 and the gate electrodes 71 of the transfer transistors TX of the pixels that are arranged in the pixel rows 401, 401S confront one another in adjacent pixel columns.

In this embodiment, in a plane that intersects the direction in which light is incident and is parallel to the +Y axis direction, the output unit 106 of the focus detection pixel 11L is provided more toward the +Y axis direction than the center of the photoelectric conversion unit 41 of the focus detection pixel 11L, and, in a plane that intersects the direction in which light is incident and parallel to the +Y axis direction, the output unit 106 of the focus detection pixel 11R is provided more toward the +Y axis direction than the center of the photoelectric conversion unit 41 of the focus detection pixel 11R. Due to this, similar beneficial effects can be obtained as in the case of the first embodiment. In other words, the incident light is reflected and photoelectrically converted in a similar manner by the focus detection pixel 11R and by the focus detection pixel 11L, so that balanced signals are outputted.

### Fifth Embodiment

A fifth embodiment will now be explained, with attention being principally concentrated upon the features of difference from the first embodiment.

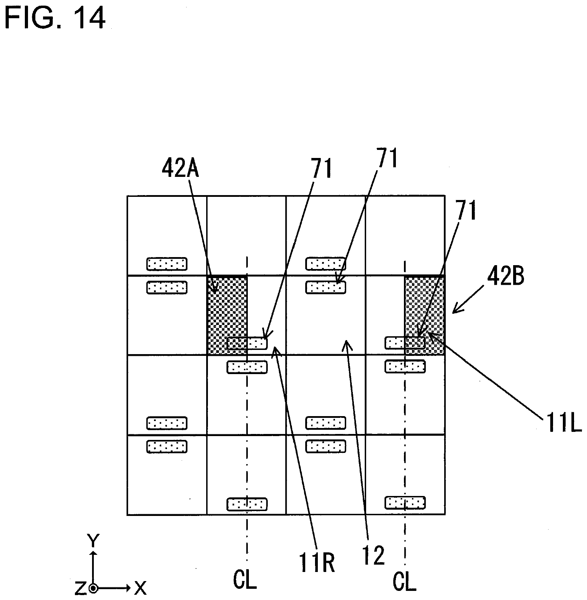

Fig. 14 is a plan view, schematically showing the circuit layout of a number of imaging pixels 12 and focus detection pixels 11R, 11L. Of the plurality of pixels that are arranged in the region 22a of the image sensor 22 that generates an image (refer to Fig. 3), Fig. 14 only shows a total of sixteen pixels arranged in a four row by four column array. In Fig. 14, each single pixel is shown by a white square surrounded by a black line. As explained in connection with Fig. 3, the focus detection pixels 11R, 11L are disposed at positions where otherwise R pixels would be located.

The gate electrodes 71 of the transfer transistors TX included in the imaging pixels 12 and the focus detection pixels 11R, 11L have the shape of rectangles that extend wider in the horizontal direction on the drawing paper (i.e. in the X axis direction). In the pixels that are disposed in the positions for G pixels, the gate electrodes 71 are disposed more toward the upward direction on the drawing paper (i.e. toward the +Y axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward a direction (i.e. toward the +Y axis direction) that intersects that direction of arrangement than the centers of the corresponding photoelectric conversion units 41.

In the pixels that are disposed in positions for R pixels and B pixels, the gate electrodes 71 are disposed more toward the downward direction on the drawing paper (i.e. toward the -Y axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward a direction opposite to a direction (i.e. toward the +Y axis direction) that intersects that direction of arrangement than the centers of the corresponding photoelectric conversion units 41.

In other words, in this embodiment, the gate electrodes 71 of the transfer transistors TX in G pixels and the gate electrodes 71 of the transfer transistors TX in adjacent R pixels or B pixels confront one another across the pixel boundaries.

In this embodiment, in a plane that intersects the direction in which light is incident and parallel to the +Y axis direction, the output unit 106 of the focus detection pixel 11L is provided more toward the direction opposite to the +Y axis direction than the center of the photoelectric conversion unit 41 of the focus detection pixel 11L, and, in a plane that intersects the direction in which light is incident and parallel to the +Y axis direction, the output unit 106 of the focus detection pixel 11R is provided more toward the direction opposite to the +Y axis direction than the center of the photoelectric conversion unit 41 of the focus detection pixel 11R. Due to this, similar beneficial effects can be obtained as in the case of the first embodiment. In other words, the incident light is reflected and photoelectrically converted in a similar manner by the focus detection pixel 11R and by the focus detection pixel 11L, so that balanced signals are outputted.

### Sixth Embodiment

A sixth embodiment will now be explained, with attention being principally concentrated upon the features of difference from the first embodiment.

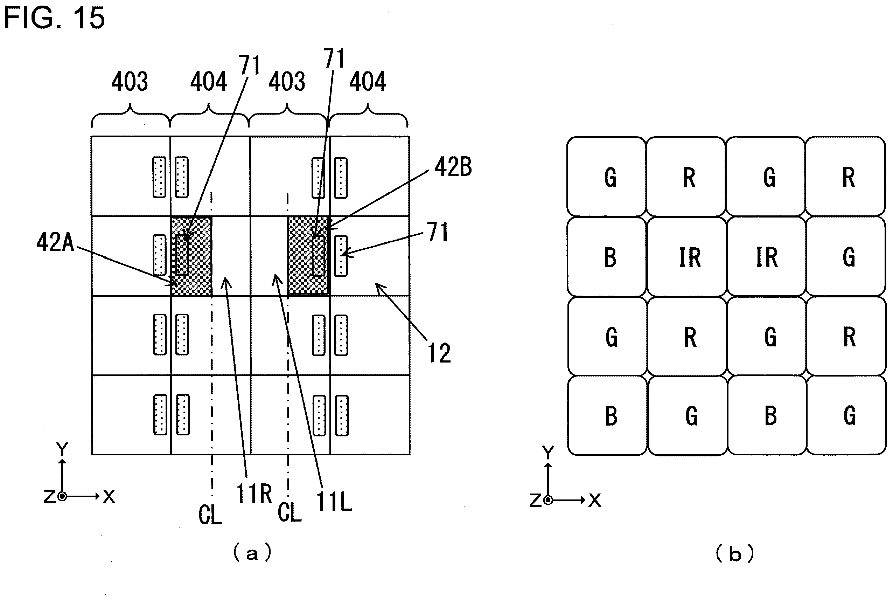

Fig. 15(a) is a plan view, schematically showing the circuit layout of a number of imaging pixels 12 and focus detection pixels 11R, 11L, and Fig. 15(b) is a plan view schematically showing the pattern of arrangement of their color filters. Of the plurality of pixels that are arranged in the region 22a of the image sensor 22 that generates an image (refer to Fig. 3), Fig. 15(a) only shows a total of sixteen pixels arranged in a four row by four column array. And the color filters of the above total of sixteen pixels are shown in Fig. 15(b). In Fig. 15(a), each single pixel is shown by a white square surrounded by a black line.

In this embodiment, color filters of a total of four types are used, with an IR (infrared light) color filter being added to the three types of color filters, i.e. R (red), G (green), and B (blue) color filters. These IR color filters principally pass light of the infrared wavelength range (i.e., infrared light). The focus detection pixels 11R, 11L have IR color filters. As shown in Fig. 15, the focus detection pixels 11R, 11L are disposed so as to replace a G pixel and a B pixel that are mutually adjacent. In the following explanation, among the pixel columns in the vertical direction (i.e. the column direction), the pixel columns that include B pixels are termed the pixel columns 403. Moreover, among the pixel columns in the vertical direction (i.e. the column direction), the pixel columns that include R pixels are termed the pixel columns 404.

The gate electrodes 71 of the transfer transistors TX included in the imaging pixels 12 and the focus detection pixels 11R, 11L have the shape of rectangles that extend taller in the vertical direction on the drawing paper (i.e. in the Y axis direction). In the pixels included in the pixel column 403, the gate electrodes 71 are disposed more toward the rightward direction on the drawing paper (i.e. toward the +X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward that direction of arrangement (i.e. the +X axis direction) than the centers of the corresponding photoelectric conversion units 41.

In the pixels included in the pixel column 404, the gate electrodes 71 are disposed more toward the leftward direction on the drawing paper (i.e. toward the -X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward the direction that is opposite to that direction of arrangement (i.e. to the +X axis direction) than the centers of the corresponding photoelectric conversion units 41.

In other words, in this embodiment, the gate electrodes 71 of the transfer transistors TX of the pixels in the pixel columns 403 and the gate electrodes 71 of the transfer transistors TX of the pixels in the pixel columns 404 confront one another across the boundaries of adjacent pixels. Moreover, in this embodiment, the focus detection pixels 11R, 11L are disposed adjacent to one another.

According to the image sensor 22 built as described above, similar beneficial effects can be obtained as in the case of the first embodiment. In other words, the incident light is reflected and photoelectrically converted in a similar manner by the focus detection pixel 11R and by the focus detection pixel 11L, so that balanced signals are outputted.

### Seventh Embodiment

A seventh embodiment will now be explained, with attention being principally concentrated upon the features of difference from the first embodiment.

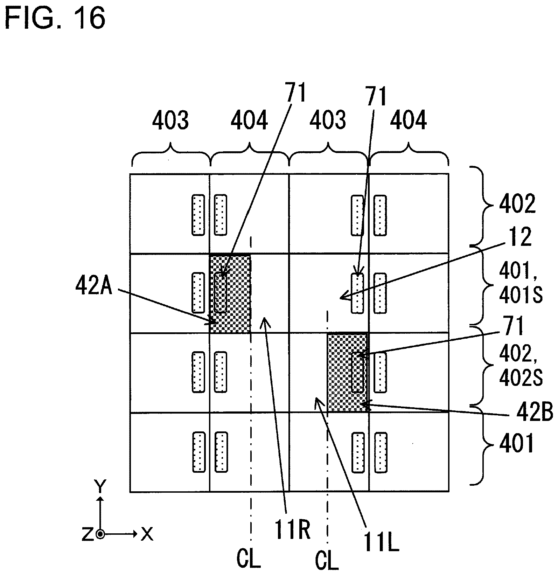

Fig. 16 is a plan view, schematically showing the circuit layout of a number of imaging pixels 12 and focus detection pixels 11R, 11L. Of the plurality of pixels that are arranged in the region 22a of the image sensor 22 that generates an image (refer to Fig. 3), Fig. 16 only shows a total of sixteen pixels arranged in a four row by four column array. In Fig. 16, each single pixel is shown by a white square surrounded by a black line. The focus detection pixels 11R, 11L are disposed at positions where otherwise G pixels would be located.

The gate electrodes 71 of the transfer transistors TX included in the imaging pixels 12 and the focus detection pixels 11R, 11L have the shape of rectangles that extend taller in the vertical direction on the drawing paper (i.e. in the Y axis direction). In the pixels that are disposed in the pixel column 403, the gate electrodes 71 are disposed more toward the rightward direction on the drawing paper (i.e. toward the +X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward that direction of arrangement (i.e. toward the +X axis direction) than the centers of the corresponding photoelectric conversion units 41.

In the pixels included in the pixel columns 404, the gate electrodes are disposed more toward the leftward direction upon the drawing paper (i.e. the -X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more in the direction opposite to that direction of arrangement (i.e. the +X axis direction) than the centers of the corresponding photoelectric conversion units 41.

In other words, in this embodiment, the gate electrodes 71 of the transfer transistors TX of the pixels in the pixel columns 403 and the gate electrodes 71 of the transfer transistors TX of the pixels in the pixel columns 404 confront one another across the boundaries of adjacent pixels.

In this embodiment, the difference from the sixth embodiment is that no IR color filters are employed. In this embodiment, both of the focus detection pixels 11R, 11L are disposed in positions where otherwise G pixels would be disposed. The focus detection pixel 11R is disposed in a pixel row 401, and the focus detection pixel 11L is disposed in a pixel row 402. Among the pixel columns 401, the reference symbol 401S is appended to the pixel row in which the focus detection pixel 11R is disposed. And, among the pixel columns 402, the reference symbol 402S is appended to the pixel row in which the focus detection pixel 11R is disposed.

In order to preserve the symmetry of the signals that are photoelectrically converted, it is desirable for one of the focus detection pixels 11R, 11L to be disposed in a pixel column 403 and the other in a pixel column 404. Moreover, it is desirable for there not to be any mutual separation of the focus detection pixels 11R, 11L in the direction in which the focus detection pixels 11R, 11L are arranged (i.e. in the X axis direction). And it is desirable for the color filters 43 of the focus detection pixels 11R, 11L to be the same. In order to satisfy all of these conditions, in this embodiment, the focus detection pixel 11R is disposed in the pixel row 401S, and the focus detection pixel 11L is disposed in the pixel row 402S that is adjacent to that pixel row 401S. In other words, the focus detection pixel 11L is disposed in a position that is separated from the focus detection pixel 11R by one pixel horizontally and by one pixel vertically. To put it in another manner, in a region where a total of four pixels are arranged in an array two rows by two columns, the focus detection pixels 11R, 11L are arranged upon a diagonal line. By doing this, and by not providing any IR color filters as in the sixth embodiment, it is possible to preserve the symmetry of the signals, and thus to perform focus detection at high accuracy.

### Eighth Embodiment

An eighth embodiment will now be explained, with attention being principally concentrated upon the features of difference from the first embodiment.

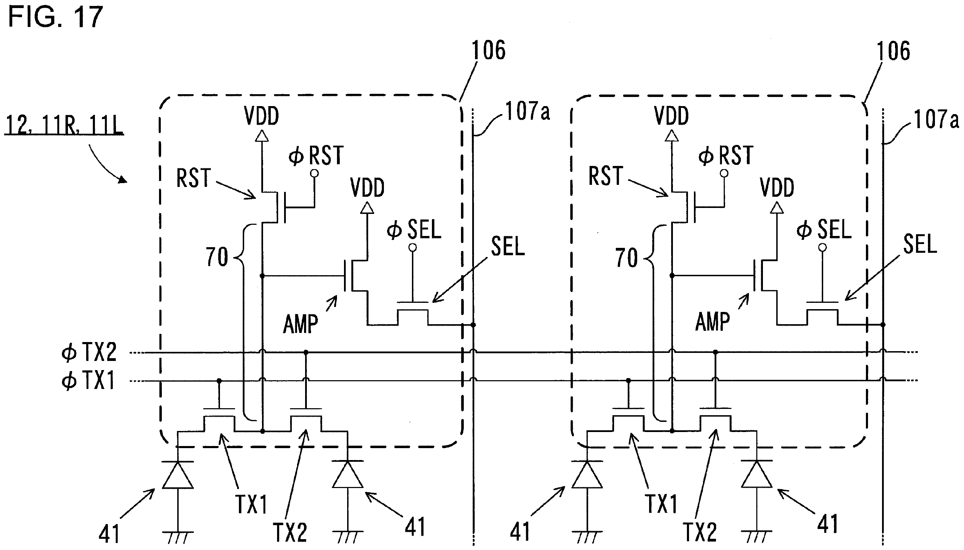

Fig. 17 is a figure showing the circuit structure of four imaging pixels 12 that are adjacent in the horizontal direction (i.e. in the row direction). It should be understood that the circuit structure of the focus detection pixels 11R, 11L is the same as the circuit structure of the imaging pixels 12 shown in Fig. 17, and accordingly explanation thereof will be curtailed.

In this embodiment, two imaging pixels that are adjacent in the horizontal direction (i.e. in the row direction) share one output unit 106. The output unit 106 of this embodiment outputs signals based upon electric charges photoelectrically converted by those two imaging pixels 12 to a vertical signal line 107a according to a time division manner.

The output unit 106 comprises a transfer transistor TX1, a transfer transistor TX2, a reset transistor RST, an amplification transistor AMP, and a selection transistor SEL. The transfer transistor TX1 transfers electric charge that has been photoelectrically converted by the photoelectric conversion unit 41 of one of the imaging pixels 12 to an accumulation unit 70. A transfer signal ϕTX1 is supplied to the gate electrode of the transfer transistor TX1. And the transfer transistor TX1 is turned on and off by this transfer signal ϕTX1. Moreover, the transfer transistor TX2 transfers electric charge that has been photoelectrically converted by the photoelectric conversion unit 41 of the other one of the imaging pixels 12 to the accumulation unit 70. A transfer signal ϕTX2 is supplied to the gate electrode of the transfer transistor TX2. And the transfer transistor TX2 is turned on and off by this transfer signal ϕTX2.

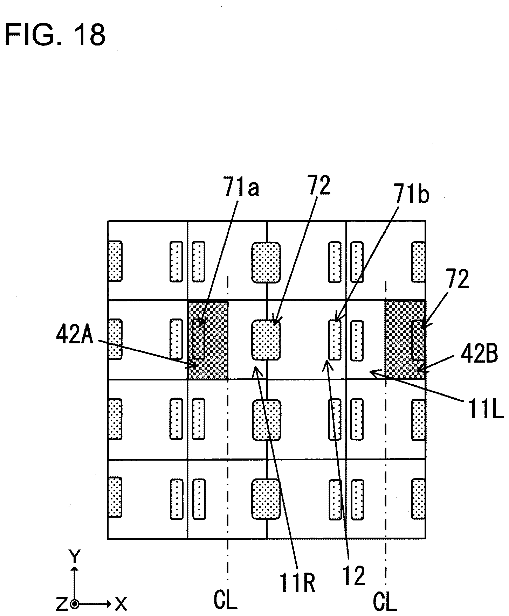

Fig. 18 is a plan view, schematically showing the circuit layout of a number of imaging pixels 12 and focus detection pixels 11R, 11L. Of the plurality of pixels that are arranged in the region 22a of the image sensor 22 that generates an image (refer to Fig. 3), Fig. 18 only shows a total of sixteen pixels arranged in a four row by four column array. In Fig. 18, each single pixel is shown by a white square surrounded by a black line. As explained in connection with Fig. 3, the focus detection pixels 11R, 11L are disposed at positions where otherwise R pixels would be located.

The gate electrodes 71b of the transfer transistors TX2 included in the imaging pixels 12 have the shape of rectangles that extend taller in the vertical direction on the drawing paper (i.e. in the Y axis direction). The gate electrodes 71b are disposed more toward the rightward direction on the drawing paper (i.e. toward the +X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71b are provided more toward that direction of arrangement (i.e. toward the +X axis direction) than the centers of the corresponding photoelectric conversion units 41.

The gate electrodes 71a of the transfer transistors TX1 included in the imaging pixels 12 and the focus detection pixels 11R, 11L have almost the same shapes as those of the gate electrodes 71b of the transfer transistors TX2. In other words, the gate electrodes 71a of the transfer transistors TX1 have the shape of rectangles that extend taller in the vertical direction on the drawing paper (i.e. in the Y axis direction). The gate electrodes 71a are disposed more toward the leftward direction on the drawing paper (i.e. toward the -X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71a are provided more toward the direction opposite to that direction of arrangement (i.e. the +X axis direction) than the centers of the corresponding photoelectric conversion units 41.

The gate electrodes 72 of the reset transistors RST shared by the two adjacent imaging pixels 12 or the focus detection pixels 11R, 11L have almost twice the area of the gate electrodes 71a, 71b of the transfer transistors TX1, TX2. The dimensions of the gate electrodes 72 in the vertical direction are almost the same as those of the gate electrodes 71a, 72b, but their dimensions in the horizontal direction are almost twice those of the gate electrodes 71a, 71b. The gate electrodes 72 are arranged so that the areas per each single pixel upon the boundary of the two pixels that share the output unit 106 (i.e. at their adjacent portions) are almost the same as those of the gate electrodes 71a, 71b.

As described above, in this embodiment, the gate electrodes 71a of the transfer transistors TX1 and the gate electrodes 72 of the reset transistors RST are arranged upon the optical paths. The gate electrodes 71a of the transfer transistors TX1 and the portions of the gate electrodes 72 of the reset transistors RST that overlap the reflective units 42B have almost the same shapes and areas, and are arranged mutually symmetrically at the left and right edges of the pixels. And, in the focus detection pixel 11L, almost half of the gate electrode 72 of the reset transistor RST is disposed upon the optical path of the light incident upon the reflective unit 42B. Moreover, in the focus detection pixel 11R, the gate electrode 71a of the transfer transistor TX1 is disposed in a position that corresponds thereto. Since, due to this, the gate electrode 71a of the transfer transistor TX1 and a part of the gate electrode 72 of the reset transistor RST are arranged symmetrically, accordingly similar beneficial effects are obtained as in the case of the first embodiment. In other words, the incident light is reflected in a similar manner by the focus detection pixel 11R and by the focus detection pixel 11L, so that balanced signals are outputted.

It should be understood that although, in the above explanation, an example was described in which, in addition to the gate electrode 71 of the transfer transistor TX, also the gate electrode 72 of the reset transistor RST was disposed upon the optical path, it would also be acceptable to provide a configuration in which, not the gate electrode 72 of the reset transistor RST, but some other member in the output unit 106, or a dummy electrode or the like, was arranged in this manner. For example, it would also be possible to arrange an electrode of the selection transistor SEL or of the amplification transistor AMP in this manner, or to provide a dummy electrode whose only purpose is to maintain the symmetry of the signals.

### Ninth Embodiment

A ninth embodiment will now be explained, with attention being principally concentrated upon the features of difference from the first embodiment.

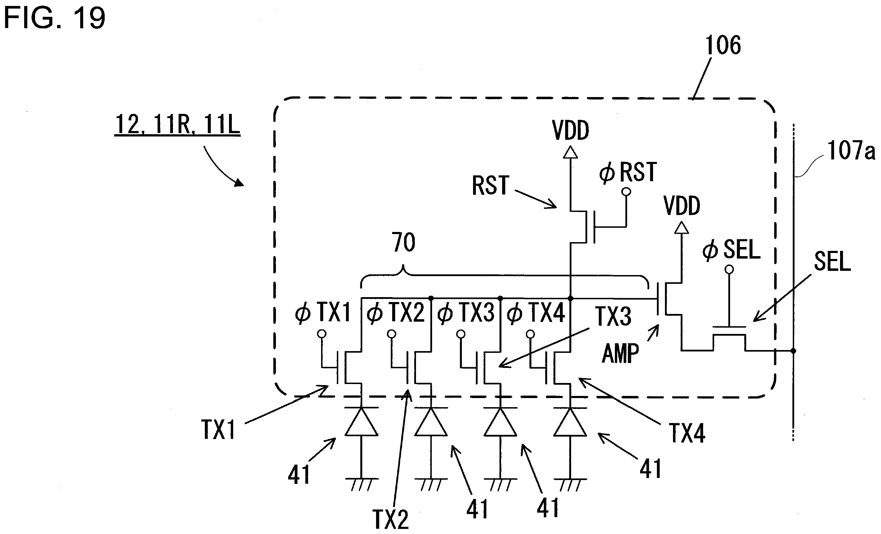

Fig. 19 is a figure showing the circuit structure of four imaging pixels 12 that are adjacent in the horizontal direction (i.e. in the row direction). It should be understood that the circuit structure of the focus detection pixels 11R, 11L is the same as the circuit structure of the imaging pixels 12 shown in Fig. 19, and accordingly explanation thereof will be curtailed.

In this embodiment, four of the imaging pixels 12 that are arranged in a two row two column array share one output unit 106. The output unit 106 of this embodiment outputs signals based upon electric charges photoelectrically converted by those four imaging pixels 12 to a vertical signal line 107a according to a time division manner.

The output unit 106 comprises a transfer transistor TX1, a transfer transistor TX2, a transfer transistor TX3, a transfer transistor TX4, a reset transistor RST, an amplification transistor AMP, and a selection transistor SEL. The transfer transistors TX1, TX2, TX3, and TX4 transfer electric charge that has been photoelectrically converted by the photoelectric conversion unit 41 of any one of the four imaging pixels 12 to an accumulation unit 70. Transfer signals ϕTX1, ϕTX2, ϕTX3, and ϕTX4 are supplied to the gate electrodes of the transfer transistors TX1, TX2, TX3, and TX4 respectively. And the transfer transistors TX1, TX2, TX3, and TX4 are respectively turned on and off by these transfer signal ϕTX1, ϕTX2, ϕTX3, and ϕTX4.

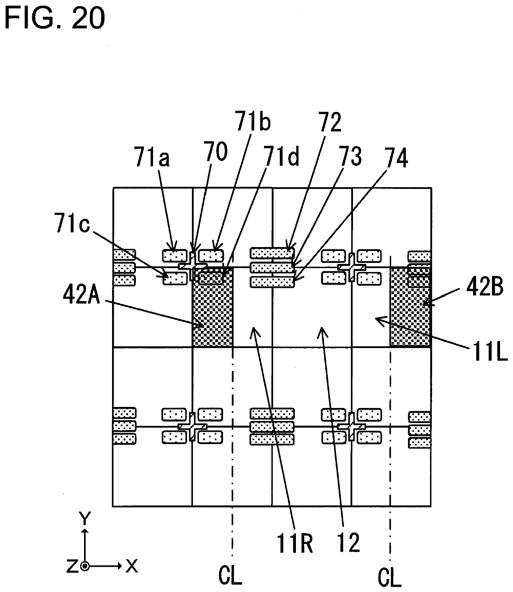

Fig. 20 is a plan view, schematically showing the circuit layout of a number of imaging pixels 12 and focus detection pixels 11R, 11L. Of the plurality of pixels that are arranged in the region 22a of the image sensor 22 that generates an image (refer to Fig. 3), Fig. 20 only shows a total of sixteen pixels arranged in a four row by four column array. In Fig. 20, each single pixel is shown by a white square surrounded by a black line. As explained in connection with Fig. 3, the focus detection pixels 11R, 11L are disposed at positions where otherwise R pixels would be located.

The gate electrodes 71a, 71b, 71c, and 71d of the transfer transistors TX1, TX2, TX3, and TX4 all have almost the same shape and dimensions. The gate electrode 71a is disposed in the lower right corner of its pixel. The gate electrode 71b is disposed in the lower left corner of its pixel. The gate electrode 71c is disposed in the upper right corner of its pixel. And the gate electrode 71d is disposed in the upper left corner of its pixel. In other words, the gate electrodes 71a, 71b, 71c, and 71d are arranged so as mutually to oppose one another around a corner point on the boundaries of the four pixels that share one output unit 106.

The accumulation unit 70 is disposed at this corner point on the boundaries of the four pixels that share the output unit 106. In Fig. 20, accumulation units 70 having the form of crosses are shown as examples of one type of the accumulation unit 70. The gate electrodes 71a, 71b, 71c, and 71d are arranged to surround the accumulation unit 70.

The gate electrode 72 of the reset transistor RST, the gate electrode 73 of the amplification transistor AMP, and the gate electrode 74 of the selection transistor SEL all have almost the same shape and dimensions. These gate electrodes 72, 73, and 74 have rectangular shapes that extend wider in the horizontal direction on the drawing paper (i.e. along the X axis direction). And, considering the gate electrodes 72, 73, and 74, approximately their left halves are disposed in regions of the two pixels on the right side, among the pixels in the array of two rows by two columns that share the output unit 106, and approximately their right halves are disposed in regions of other pixels. In other words: the gate electrodes 71a, 71b, 71c, and 71d and the accumulation unit 70 are disposed in the neighborhood of the center of the total of four pixels arranged in an array of two rows by two columns; approximately the right halves of the gate electrodes 72, 73, and 74 are disposed on the center left side of the total of four pixels arranged in an array of two rows by two columns, and have no relationship to those four pixels; and approximately the left halves of the gate electrodes 72, 73, and 74 of the output unit 106 shared by the total of four pixels arranged in an array of two rows by two columns are disposed on the center right side of those four pixels.

The focus detection pixels 11R, 11L are disposed in pixel positions at the lower right of totals of four pixels arranged in arrays of two rows by two columns that share output units 106. The gate electrode 71d of the transfer transistor TX4 is provided upon the optical path of light reflected by the reflective unit 42A. And a part of the gate electrode 73 of the amplification transistor AMP and a part of the gate electrode 74 of the selection transistor SEL are provided upon the optical path of the light reflected by the reflective unit 42B. The area and the shape of the gate electrode 71d at the reflective unit 42A and the areas and the shapes of the gate electrodes 73, 74 at the reflective unit 42B are almost equal. Moreover, their positions are almost bilaterally symmetric with respect to the Y axis. Since those gate electrodes are arranged symmetrically in this manner, accordingly similar beneficial effects are obtained as in the case of the first embodiment. In other words, the incident light is reflected in a similar manner by the focus detection pixel 11R and by the focus detection pixel 11L, so that balanced signals are outputted.

### Tenth Embodiment

A tenth embodiment will now be explained, with attention being principally concentrated upon the features of difference from the first embodiment.

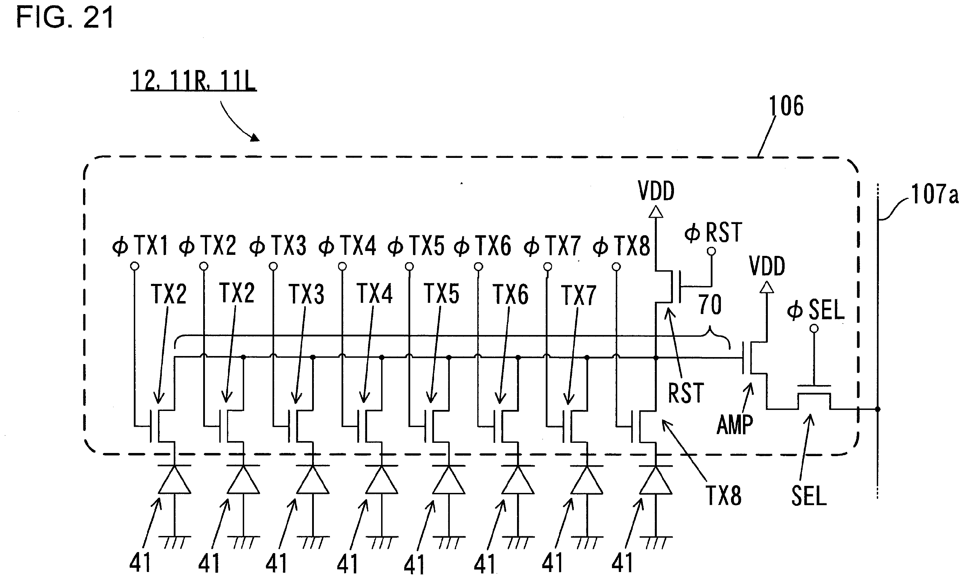

Fig. 21 is a figure showing the circuit structure of a total of eight imaging pixels, arranged in an array four rows by two columns. It should be understood that the circuit structure of the focus detection pixels 11R, 11L is the same as the circuit structure of the imaging pixels 12 shown in Fig. 21, and accordingly explanation thereof will be curtailed.

In this embodiment, the total of eight imaging pixels 12 arranged in an array four rows by two columns share an output unit 106. The output unit 106 of this embodiment outputs signals based upon electric charges photoelectrically converted by those eight imaging pixels 12 to a vertical signal line 107a according to a time division manner.

The output unit 106 comprises a transfer transistor TX1, a transfer transistor TX2, a transfer transistor TX3, a transfer transistor TX4, a transfer transistor TX5, a transfer transistor TX7, a transfer transistor TX7, a transfer transistor TX8, a reset transistor RST, an amplification transistor AMP, and a selection transistor SEL. The transfer transistors TX1 through TX8 transfer electric charge that has been photoelectrically converted by the photoelectric conversion unit 41 of any one of the eight imaging pixels 12 to an accumulation unit 70. Transfer signals ϕTX1 through ϕTX8 are supplied to the gate electrodes of the transfer transistors TX1 through TX8 respectively. And the transfer transistors TX1 through TX8 are respectively turned on and off by these transfer signal ϕTX1 through ϕTX8.

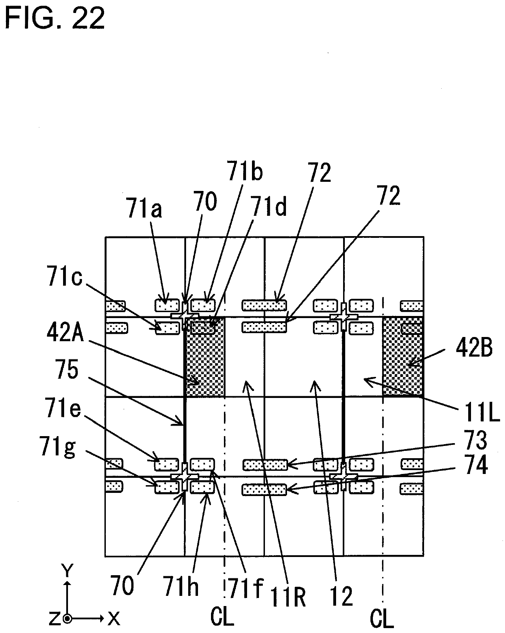

Fig. 22 is a plan view, schematically showing the circuit layout of a number of imaging pixels 12 and focus detection pixels 11R, 11L. Of the plurality of pixels that are arranged in the region 22a of the image sensor 22 that generates an image (refer to Fig. 3), Fig. 22 only shows a total of sixteen pixels arranged in a four row by four column array. In Fig. 22, each single pixel is shown by a white square surrounded by a black line. As explained in connection with Fig. 3, the focus detection pixels 11R, 11L are disposed at positions where otherwise R pixels would be located.

The respective gate electrodes 71a, 71b, 71c, 71d, 71e, 71f, 71g, and 71h of the transfer transistors TX1, TX2, TX3, TX4, TX5, TX6, TX7, and TX8 all have almost the same shape and dimensions.

The gate electrode 71a is disposed in the lower right corner of its pixel. The gate electrode 71b is disposed in the lower left corner of its pixel. The gate electrode 71c is disposed in the upper right corner of its pixel. And the gate electrode 71d is disposed in the upper left corner of its pixel. In other words, the gate electrodes 71a, 71b, 71c, and 71d are arranged so as mutually to oppose one another around a corner point on the boundaries of four of the eight pixels that share one output unit 106, and that are arranged in an array of two rows by two columns.

Moreover, the gate electrode 71e is disposed in the lower right corner of its pixel. The gate electrode 71f is disposed in the lower left corner of its pixel. The gate electrode 71g is disposed in the upper right corner of its pixel. And the gate electrode 71h is disposed in the upper left corner of its pixel. In other words, the gate electrodes 71e, 71f, 71g, and 71h are arranged so as mutually to oppose one another around a corner point on the boundaries of the four of the eight pixels that share one output unit 106 other than the four pixels having the gate electrodes 71a through 71d, and which are similarly arranged in another array of two rows by two columns.

A portion of the accumulation unit 70 is disposed at the corner point on the boundaries of the four pixels arranged in an array of two rows by two columns, among the eight pixels that share the output unit 106. In Fig. 22, portions of the accumulation unit 70 having the form of crosses are shown as examples of one type of the accumulation unit 70. The gate electrodes 71a, 71b, 71c, and 71d are arranged to surround this portion of the accumulation unit 70.

Moreover, the other portion of the accumulation unit 70 is disposed at the corner point on the boundaries of the other four pixels arranged in another array of two rows by two columns, among the eight pixels that share the output unit 106. The gate electrodes 71e, 71f, 71g, and 71h are arranged to surround this other portion of the accumulation unit 70.

The portion of the accumulation unit 70 surrounded by the gate electrodes 71a, 71b, 71c, and 71d, and the remaining portion of the accumulation unit 70 surrounded by the gate electrodes 71e, 71f, 71g, and 71h, are electrically connected by wiring 75.

The gate electrode 72 of the reset transistor RST, the gate electrode 73 of the amplification transistor AMP, and the gate electrode 74 of the selection transistor SEL all have almost the same shape and dimensions. These gate electrodes 72, 73, and 74 have rectangular shapes that extend wider in the horizontal direction on the drawing paper (i.e. along the X axis direction). And the arrangements of the gate electrodes 72 of the eight pixels arranged in an array of four rows by two columns that share the output unit 106 are different. With some of the gate electrodes 72, approximately their left halves are disposed in regions of the pixels at the upper right corners, among the pixels in the array of four rows by two columns that share the output unit 106, and approximately their right halves are disposed in regions of other pixels. But with others of the gate electrodes 72, approximately their right halves are disposed in regions of pixels one below pixels at the upper left corners, among the pixels in an array of four rows by two columns that share an output unit 106, while approximately their left halves are disposed in regions of other pixels. And, in the case of the gate electrodes 73, approximately their left halves are disposed in regions of pixels one above pixels at the lower right corners, among the pixels in an array of four rows by two columns that share an output unit 106, while approximately their right halves are disposed in regions of other pixels. Moreover, in the case of the gate electrodes 74, approximately their left halves are disposed in regions of the pixels at the lower right corners, among the pixels in an array of four rows by two columns that share an output unit 106, while approximately their right halves are disposed in regions of other pixels.

The focus detection pixels 11R, 11L are disposed in the positions of pixels one below the pixels at the upper right corners of totals of eight pixels arranged in arrays of four rows by two columns that share output units 106. The gate electrode 71d of the transfer transistor TX4 is provided upon the optical path of light reflected by the reflective unit 42A. And a part of the gate electrode 72 of another pixel is provided upon the optical path of the light reflected by the reflective unit 42B. The area and the shape of the gate electrode 71d at the reflective unit 42A and the area and the shape of the gate electrode 72 at the reflective unit 42B are almost equal. Moreover, their positions are almost bilaterally symmetric with respect to the Y axis. Since those gate electrodes are arranged symmetrically in this manner, accordingly similar beneficial effects are obtained as in the case of the first embodiment. In other words, the incident light is reflected in a similar manner by the focus detection pixel 11R and by the focus detection pixel 11L, so that balanced signals are outputted.

### Eleventh Embodiment

An eleventh embodiment will now be explained, with attention being principally concentrated upon the features of difference from the tenth embodiment.

In this embodiment, the imaging pixels 12 and the focus detection pixels 11R, 11L have similar circuit structures to the case of the tenth embodiment shown in Fig. 21. In this embodiment, the total of eight imaging pixels 12 arranged in an array four rows by two columns share an output unit 106. The output unit 106 of this embodiment outputs signals based upon electric charges photoelectrically converted by those eight imaging pixels 12 to a vertical signal line 107a according to a time division manner.

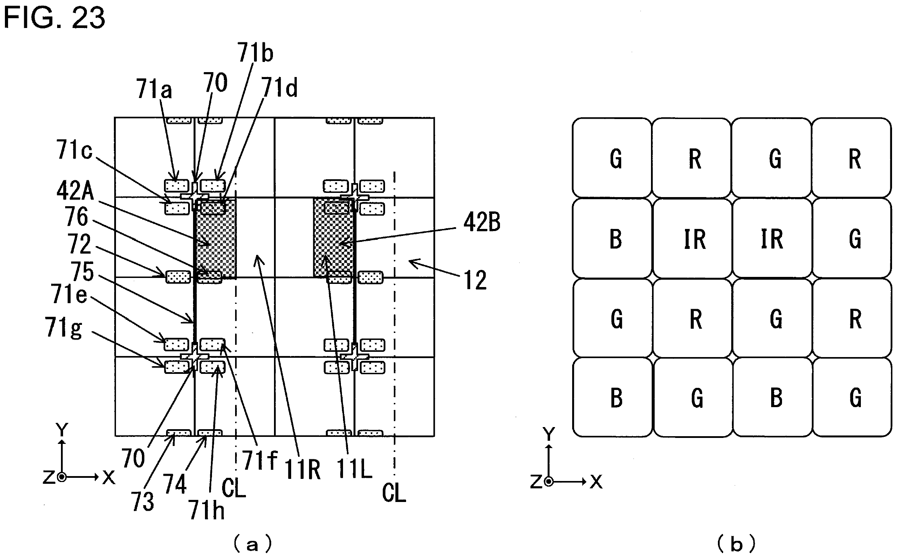

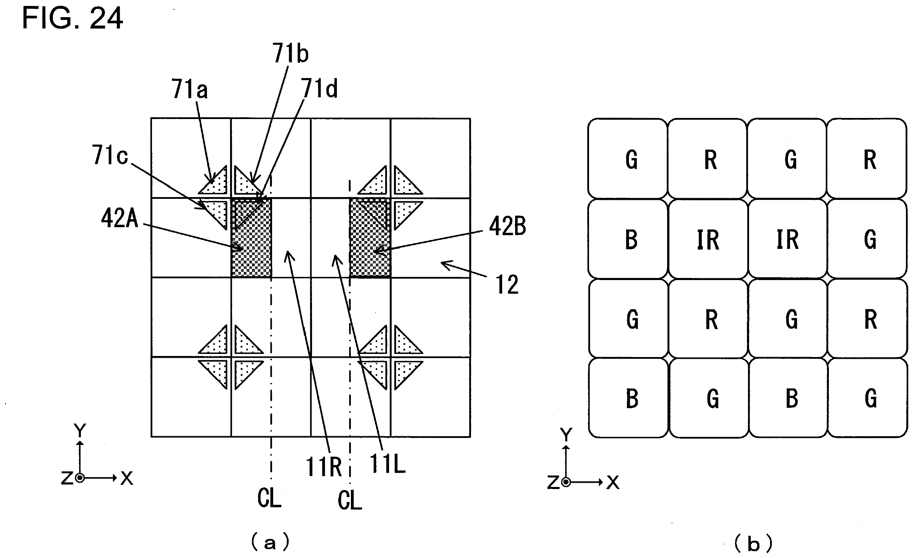

Fig. 23(a) is a plan view, schematically showing the circuit layout of a number of imaging pixels 12 and focus detection pixels 11R, 11L, and Fig. 23(b) is a plan view schematically showing the pattern of arrangement of their color filters. Of the plurality of pixels that are arranged in the region 22a of the image sensor 22 that generates an image (refer to Fig. 3), Fig. 23(a) only shows a total of sixteen pixels arranged in a four row by four column array. In Fig. 24(a), each single pixel is shown by a white square surrounded by a black line. And the color filters of the above total of sixteen pixels are shown in Fig. 23(b).

The respective gate electrodes 71a, 71b, 71c, 71d, 71e, 71f, 71g, and 71h of the transfer transistors TX1, TX2, TX3, TX4, TX5, TX6, TX7, and TX8 all have almost the same shape and dimensions.

The gate electrode 71a is disposed in the lower right corner of its pixel. The gate electrode 71b is disposed in the lower left corner of its pixel. The gate electrode 71c is disposed in the upper right corner of its pixel. And the gate electrode 71d is disposed in the upper left corner of its pixel. In other words, the gate electrodes 71a, 71b, 71c, and 71d are arranged so as mutually to oppose one another around a corner point on the boundaries of four of the eight pixels that share one output unit 106, and that are arranged in an array of two rows by two columns.

The gate electrode 71e is disposed in the lower right corner of its pixel. The gate electrode 71f is disposed in the lower left corner of its pixel. The gate electrode 71g is disposed in the upper right corner of its pixel. And the gate electrode 71h is disposed in the upper left corner of its pixel. In other words, the gate electrodes 71e, 71f, 71g, and 71h are arranged so as mutually to oppose one another around a corner point on the boundaries of the four of the eight pixels that share one output unit 106 other than the four pixels having the gate electrodes 71a through 71d, and which are similarly arranged in another array of two rows by two columns.

A part of the accumulation unit 70 is disposed at the corner point on the boundaries of the four pixels arranged in an array of two rows by two columns, among the eight pixels that share the output unit 106. In Fig. 22, portions of the accumulation unit 70 having the form of crosses are shown as examples of one type of the accumulation unit 70. The gate electrodes 71a, 71b, 71c, and 71d are arranged to surround this portion of the accumulation unit 70.

Moreover, the other portion of the accumulation unit 70 is disposed at the corner point on the boundaries of the other four pixels arranged in another array of two rows by two columns, among the eight pixels that share the output unit 106. The gate electrodes 71e, 71f, 71g, and 71h are arranged to surround this other portion of the accumulation unit 70.

The portion of the accumulation unit 70 surrounded by the gate electrodes 71a, 71b, 71c, and 71d, and the remaining portion of the accumulation unit 70 surrounded by the gate electrodes 71e, 71f, 71g, and 71h, are electrically connected by wiring 75.

The gate electrodes 71a through 71h of the transfer transistors TX1 through TX8, the gate electrode 72 of the reset transistor RST, the gate electrode 73 of the amplification transistor AMP, and the gate electrode 74 of the selection transistor SEL all have almost the same shape and dimensions. The gate electrode 72 is disposed upon the boundary between, among the array of four rows by two columns of pixels that share the output unit 106, the pixel one below the pixel at the upper left corner and the pixel one above the pixel at the lower left corner. As for the gate electrode 73, among the array of four rows by two columns of pixels that share the output unit 106, its approximately upper half is disposed in the region of the pixel at the lower left corner, and its approximately lower half is disposed in the region of some other pixel. And, with the gate electrode 74, among the array of four rows by two columns of pixels that share the output unit 106, its approximately upper half is disposed in the region of the pixel at the lower right corner, and its approximately lower half is disposed in the region of some other pixel.

The output unit 106 further comprises a dummy electrode 76. This dummy electrode 76 is an electrode that has no relationship to the circuitry shown by way of example in Fig. 21, and is an electrode that is provided in order to preserve the symmetry of the output signals of the reflective units 42A, 42B. The dummy electrode 76 is disposed upon the boundary between the pixel one below the upper right corner pixel, among the eight pixels arranged in a four row two column array that share the output unit 106, and the pixel one above the lower right corner pixel.

In this embodiment, color filters of a total of four types are used, with an IR (infrared light) color filter being added to the three types of color filters, i.e. R (red), G (green), and B (blue) color filters. These IR color filters principally pass light of the infrared wavelength range (infrared light). The focus detection pixels 11R, 11L have IR color filters. As shown in Fig. 23(b), the focus detection pixels 11R, 11L are disposed to replace a G pixel and a B pixel that are mutually adjacent.

The focus detection pixel 11R is disposed in the position of a pixel one below the pixel at the upper right corner of the total of eight pixels arranged in an array of four rows by two columns that share the output unit 106. And the focus detection pixel 11L is disposed at a pixel position one below the pixel at the upper left corner of the total of eight pixels arranged in an array of four rows by two columns that share the output unit 106. The gate electrode 71d of the transfer transistor TX4 and a portion (the upper half) of a dummy electrode 76 are provided upon the optical path of light reflected by the reflective unit 42A. And the gate electrode 71c of the transfer transistor TX3 and a portion (the upper half) of the gate electrode 72 of the reset transistor RST are provided upon the optical path of the light reflected by the reflective unit 42B. The area and the shape of the gate electrode 71d at the reflective unit 42A and the area and the shape of the gate electrode 71c at the reflective unit 42B are almost equal. Furthermore, the area and the shape of the part of the dummy electrode 76 at the reflective unit 42A and the area and the shape of the part of the gate electrode 72 at the reflective unit 42B are almost equal. Moreover, their positions are almost bilaterally symmetric with respect to the Y axis. Since those gate electrodes are arranged symmetrically in this manner, accordingly similar beneficial effects are obtained as in the case of the first embodiment. In other words, the incident light is reflected in a similar manner by the focus detection pixel 11R and by the focus detection pixel 11L, so that balanced signals are outputted.

### Twelfth Embodiment

A twelfth embodiment will now be explained, with attention being principally concentrated upon the features of difference from the tenth embodiment.

In this embodiment, the imaging pixels 12 and the focus detection pixels 11R, 11L have circuit structures that are similar to those in the ninth embodiment shown in Fig. 19. In this embodiment, a total of four of the imaging pixels 12 arranged in an array two rows by two columns share one output unit 106. The output unit 106 of this embodiment outputs signals based upon electric charges photoelectrically converted by those four imaging pixels 12 to a vertical signal line 107a according to a time division manner.

Fig. 24(a) is a plan view, schematically showing the circuit layout of a number of imaging pixels 12 and focus detection pixels 11R, 11L, and Fig. 24(b) is a plan view schematically showing the pattern of arrangement of their color filters. Of the plurality of pixels that are arranged in the region 22a of the image sensor 22 that generates an image (refer to Fig. 3), Fig. 24(a) only shows a total of sixteen pixels arranged in a four row by four column array. In Fig. 24(a), each single pixel is shown by a white square surrounded by a black line. And the color filters of the above total of sixteen pixels are shown in Fig. 24(b).

The gate electrodes 71a, 71b, 71c, and 71d of the transfer transistors TX1, TX2, TX3, and TX4 all have almost the same shape and dimensions, but have different orientations. The gate electrodes 71a, 71b, 71c, and 71d are almost shaped as right angled isosceles triangles. The gate electrode 71a is disposed in the lower right corner of its pixel. The gate electrode 71b is disposed in the lower left corner of its pixel. The gate electrode 71c is disposed in the upper right corner of its pixel. And the gate electrode 71d is disposed in the upper left corner of its pixel. In other words, the gate electrodes 71a, 71b, 71c, and 71d are arranged so as mutually to oppose one another around a corner point on the boundaries of the four pixels that share one output unit 106. The right angles of the gate electrodes 71a, 71b, 71c, and 71d are arranged so as to oppose one another around that corner point on the boundaries of the four pixels.

In this embodiment, color filters of a total of four types are used, with an IR (infrared light) color filter being added to the three types of color filters, i.e. R (red), G (green), and B (blue) color filters. These IR color filters principally pass light of the infrared wavelength range (infrared light). The focus detection pixels 11R, 11L have IR color filters. As shown in Fig. 24(b), the focus detection pixels 11R, 11L are disposed to replace a G pixel and a B pixel that are mutually adjacent.

The focus detection pixel 11R is disposed at a pixel position at the lower right corner of a total of four pixels arranged in an array of two rows by two columns that share an output unit 106. And the focus detection pixel 11L is disposed at a pixel position at the lower left corner of a total of four pixels arranged in an array of two rows by two columns that share an output unit 106. The gate electrode 71d of the transfer transistor TX4 is provided upon the optical path of the light reflected by the reflective unit 42A. And the gate electrode 71c of the transfer transistor TX3 is provided upon the optical path of the light reflected by the reflective unit 42B. The area and the shape of the gate electrode 71d at the reflective unit 42A and the area and the shape of the gate electrode 71c at the reflective unit 42B are almost equal. Moreover, their positions are almost bilaterally symmetric with respect to the Y axis. Since those electrodes are arranged symmetrically in this manner, accordingly similar beneficial effects are obtained as in the case of the first embodiment. In other words, the incident light is reflected in a similar manner by the focus detection pixel 11R and by the focus detection pixel 11L, so that balanced signals are outputted.

### Thirteenth Embodiment

A thirteenth embodiment will now be explained, with attention being principally concentrated upon the features of difference from the first embodiment.

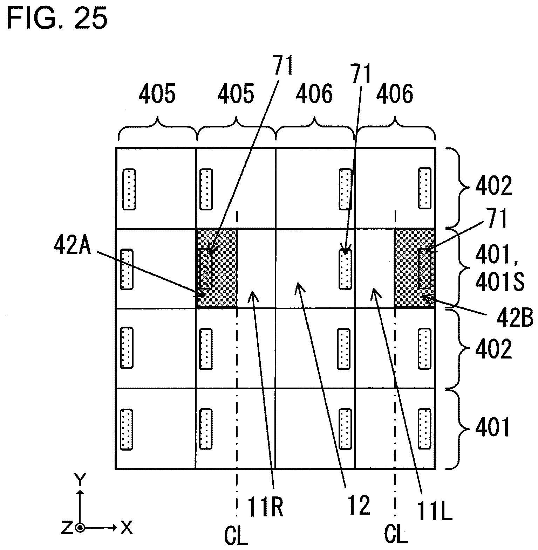

Fig. 25 is a plan view, schematically showing the circuit layout of a number of imaging pixels 12 and focus detection pixels 11R, 11L. Of the plurality of pixels that are arranged in the region 22a of the image sensor 22 that generates an image (refer to Fig. 3), Fig. 25 only shows a total of sixteen pixels arranged in a four row by four column array. In Fig. 25, each single pixel is shown by a white square surrounded by a black line. As explained in connection with Fig. 3, the focus detection pixels 11R, 11L are disposed at positions where otherwise R pixels would be located.

In this embodiment, the gate electrodes 71 of the transfer transistors TX are arranged in different positions in every two columns. In the following explanation, among the four pixel columns shown in Fig. 25, each of the left two pixel columns will be termed a pixel column 405, and each of the right two pixel columns will be termed a pixel column 406.

The gate electrodes 71 of the transfer transistors TX included in the imaging pixels 12 and the focus detection pixels 11R, 11L have the shape of rectangles that extend taller in the vertical direction on the drawing paper (i.e. in the Y axis direction). In the pixels that are included in the pixel row 405, the gate electrodes 71 are disposed more toward the leftward direction on the drawing paper (i.e. toward the -X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward the direction opposite to that direction of arrangement (i.e. the +X axis direction) than the centers of the corresponding photoelectric conversion units 41.

In the pixels included in the pixel row 406, the gate electrodes 71 are disposed more toward the rightward direction upon the drawing paper (i.e. toward the +X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward that direction of arrangement (i.e. the +X axis direction) than the centers of the corresponding photoelectric conversion units 41.

The focus detection pixels 11R, 11L are disposed in the same pixel row 401S. And, among the two pixel columns 405, the focus detection pixel 11R is disposed in the column to the right side. Moreover, among the two pixel columns 406, the focus detection pixel 11L is disposed in the column to the left side.

In the focus detection pixel 11L, the gate electrode 71 of the transfer transistor TX is disposed upon the optical path of light incident upon the reflective unit 42B. And, in the focus detection pixel 11R, the gate electrode 71 of the transfer transistor TX is disposed in a corresponding position. Since those gate electrodes 71 of the transfer transistors TX are arranged symmetrically in this manner, accordingly similar beneficial effects are obtained as in the case of the first embodiment. In other words, the incident light is reflected in a similar manner by the focus detection pixel 11R and by the focus detection pixel 11L, so that balanced signals are outputted.

### Fourteenth Embodiment

A fourteenth embodiment will now be explained, with attention being principally concentrated upon the features of difference from the first embodiment.

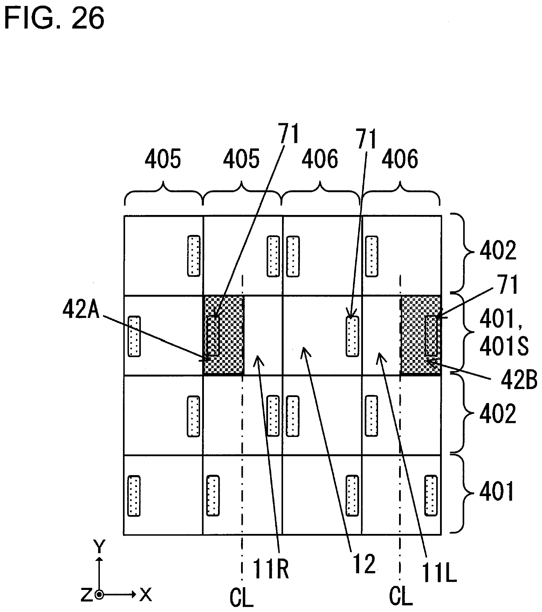

Fig. 26 is a plan view, schematically showing the circuit layout of a number of imaging pixels 12 and focus detection pixels 11R, 11L. Of the plurality of pixels that are arranged in the region 22a of the image sensor 22 that generates an image (refer to Fig. 3), Fig. 26 only shows a total of sixteen pixels arranged in a four row by four column array. In Fig. 26, each single pixel is shown by a white square surrounded by a black line. As explained in connection with Fig. 3, the focus detection pixels 11R, 11L are disposed at positions where otherwise R pixels would be located.

In this embodiment, the gate electrodes 71 of the transfer transistors TX are arranged in different positions in every two columns. In the following explanation, among the four pixel columns shown in Fig. 26, the left two pixel columns will both be termed pixel columns 405, and the right two pixel columns will both be termed pixel columns 406.

The gate electrodes 71 of the transfer transistors TX included in the imaging pixels 12 and the focus detection pixels 11R, 11L have the shape of rectangles that extend taller in the vertical direction on the drawing paper (i.e. in the Y axis direction). In the pixels that are included in the pixel columns 405 and moreover are also included in the pixel rows 401, the gate electrodes 71 are disposed more toward the leftward direction on the drawing paper (i.e. toward the -X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), these gate electrodes 71 are provided more toward the direction opposite to that direction of arrangement (i.e. the +X axis direction) than the centers of the corresponding photoelectric conversion units 41. It should be understood that the same holds for the pixels that are included in the pixel columns 406 and that moreover are also included in the pixel rows 402.

In the pixels that are included in the pixel columns 405 and moreover are included in the pixel rows 402, the gate electrodes 71 are disposed more toward the rightward direction on the drawing paper (i.e. toward the +X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), these gate electrodes 71 are provided more toward that direction of arrangement (i.e. toward the +X axis direction) than the centers of the corresponding photoelectric conversion units 41. It should be understood that the same holds for the pixels that are included in the pixel columns 406 and that moreover are also included in the pixel rows 401.

The focus detection pixels 11R, 11L are disposed in the same pixel row 401S. Among the two pixel columns 405, the focus detection pixel 11R is disposed in the right side column. Moreover, among the two pixel columns 406, the focus detection pixel 11R is disposed in the right side column.

In the focus detection pixel 11L, the gate electrode 71 of the transfer transistor TX is provided upon the optical path of light incident upon the reflective unit 42B. And, in the focus detection pixel 11R, the gate electrode 71 of the transfer transistor TX is provided in a position corresponding thereto. Since those gate electrodes 71 of the transfer transistors TX are arranged symmetrically in this manner, accordingly similar beneficial effects are obtained as in the case of the first embodiment. In other words, the incident light is reflected in a similar manner by the focus detection pixel 11R and by the focus detection pixel 11L, so that balanced signals are outputted.

### Fifteenth Embodiment

A fifteenth embodiment will now be explained, with attention being principally concentrated upon the features of difference from the first embodiment.

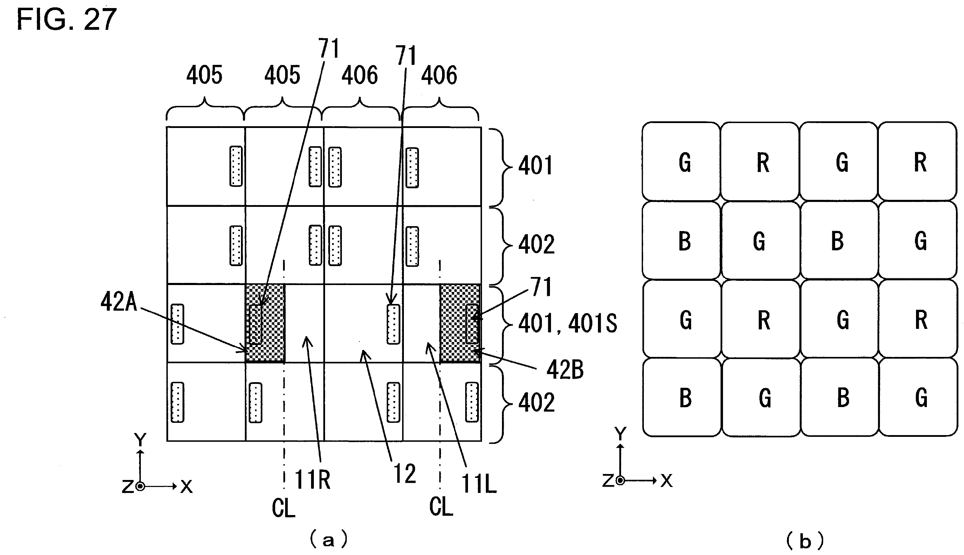

Fig. 27(a) is a plan view, schematically showing the circuit layout of a number of imaging pixels 12 and focus detection pixels 11R, 11L, and Fig. 27(b) is a plan view schematically showing the pattern of arrangement of their color filters. Of the plurality of pixels that are arranged in the region 22a of the image sensor 22 that generates an image (refer to Fig. 3), Fig. 27(a) only shows a total of sixteen pixels arranged in a four row by four column array. And the color filters of the above total of sixteen pixels are shown in Fig. 27(b). In Fig. 27(a), each single pixel is shown by a white square surrounded by a black line. As explained in connection with Fig. 3, the focus detection pixels 11R, 11L are disposed at positions where otherwise R pixels would be located.

The gate electrodes 71 of the transfer transistors TX included in the imaging pixels 12 and the focus detection pixels 11R, 11L have the shape of rectangles that extend taller in the vertical direction on the drawing paper (i.e. in the Y axis direction). In this embodiment, the gate electrodes 71 of the transfer transistors TX are arranged in different positions for each group of two rows by two columns.

Among the pixels shown in Fig. 27(a), in the total of four pixels in a two row by two column array at the upper left, the gate electrodes 71 are disposed more in the rightward direction upon the drawing paper (i.e. more in the +X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), these gate electrodes 71 are provided more toward that direction of arrangement (i.e. toward the +X axis direction) than the centers of the corresponding photoelectric conversion units 41. And it should be understood that the same holds for the total of four pixels in a two row by two column array at the lower right, among the pixels shown in Fig. 27(a).

Moreover, among the pixels shown in Fig. 27(a), in the total of four pixels in a two row by two column array at the upper right, the gate electrodes 71 are disposed more in the leftward direction upon the drawing paper (i.e. the -X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), these gate electrodes 71 are provided more toward a direction opposite to that direction of arrangement (i.e. the +X axis direction) than the centers of the corresponding photoelectric conversion units 41. And it should be understood that the same holds for the total of four pixels in a two row by two column array at the lower left, among the pixels shown in Fig. 27(a).

The focus detection pixels 11R, 11L are disposed in the same pixel row 401S. In the focus detection pixel 11L, the gate electrode 71 of the transfer transistor TX is provided upon the optical path of light incident upon the reflective unit 42B. And, in the focus detection pixel 11R, the gate electrode 71 of the transfer transistor TX is provided in a position corresponding thereto. Since these gate electrodes 71 of the transfer transistors TX are arranged symmetrically in this manner, accordingly similar beneficial effects are obtained as in the case of the first embodiment. In other words, the incident light is reflected in a similar manner by the focus detection pixel 11R and by the focus detection pixel 11L, so that balanced signals are outputted.

### Sixteenth Embodiment

A sixteenth embodiment will now be explained, with attention being principally concentrated upon the features of difference from the first embodiment.

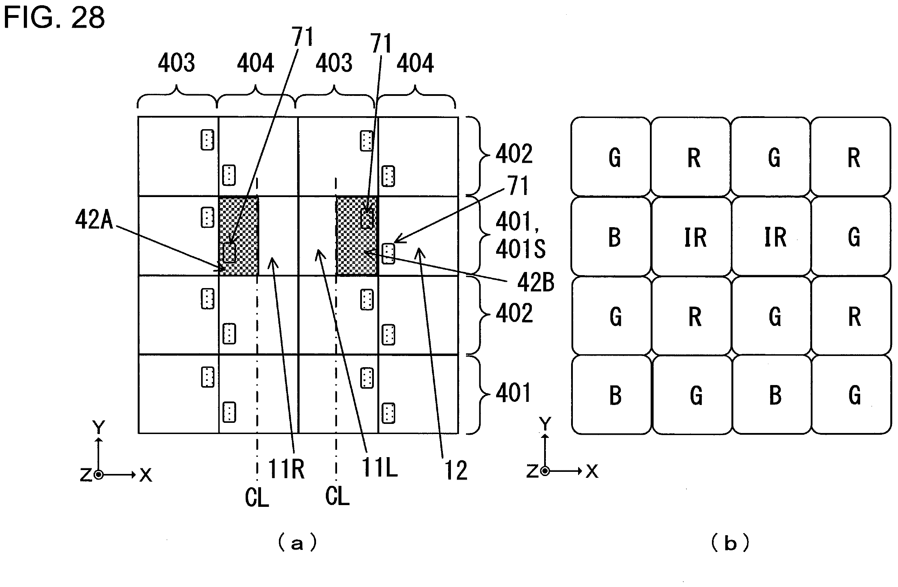

Fig. 28(a) is a plan view, schematically showing the circuit layout of a number of imaging pixels 12 and focus detection pixels 11R, 11L, and Fig. 28(b) is a plan view schematically showing the pattern of arrangement of their color filters. Of the plurality of pixels that are arranged in the region 22a of the image sensor 22 that generates an image (refer to Fig. 3), Fig. 28(a) only shows a total of sixteen pixels arranged in a four row by four column array. And the color filters of the above total of sixteen pixels are shown in Fig. 28(b). In Fig. 28(a), each single pixel is shown by a white square surrounded by a black line.

In this embodiment, color filters of a total of four types are used, with an IR (infrared light) color filter being added to the three types of color filters, i.e. R (red), G (green), and B (blue) color filters. These IR color filters principally pass light of the infrared wavelength range (infrared light). The focus detection pixels 11R, 11L have IR color filters. As shown in Fig. 28, the focus detection pixels 11R, 11L are disposed to replace a G pixel and a B pixel that are mutually adjacent. In the following explanation, among the pixel columns in the vertical direction (i.e. in the column direction), the pixel columns that include B pixels are termed the pixel columns 403. Moreover, among the pixel columns in the vertical direction (i.e. in the column direction), the pixel columns that include R pixels are termed the pixel columns 404.

The gate electrodes 71 of the transfer transistors TX included in the imaging pixels 12 and the two focus detection pixels 11R, 11L have the shape of rectangles that extend taller in the vertical direction on the drawing paper (i.e. in the Y axis direction). The size of the gate electrodes in the Y axis direction is half or less of the size of the photoelectric conversion units 41 in the Y axis direction. In the pixels that are included in the pixel columns 403, the gate electrodes 71 are disposed more toward the upward and rightward direction on the drawing paper (i.e. toward the +X axis direction and the +Y axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward the direction of arrangement (the +X axis direction) and moreover toward a direction (the +Y axis direction) that intersects that direction of arrangement (the +X axis direction), than the centers of the corresponding photoelectric conversion units 41.

In the pixels included in the pixel columns 404, the gate electrodes 71 are disposed more toward the downward and leftward direction on the drawing paper (i.e. toward the -X axis direction and the -Y axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward a direction opposite to the direction of arrangement (i.e. the +X axis direction) and moreover toward a direction (the -Y axis direction) that intersects that direction of arrangement (the +X axis direction), than the centers of the corresponding photoelectric conversion units 41.

The gate electrode 71 of the transfer transistor TX is provided at the lower left corner upon the optical path of light reflected by the reflective unit 42A. And the gate electrode 71 of the transfer transistor TX is provided at the upper right corner upon the optical path of light reflected by the reflective unit 42B. The area and the shape of the gate electrode 71 at the reflective unit 42A and the area and the shape of the gate electrode 71 at the reflective unit 42B are almost equal. Moreover, their positions are almost point symmetric with respect to the center of the photoelectric conversion unit 41. Since those gate electrodes are arranged symmetrically in this manner, accordingly similar beneficial effects are obtained as in the case of the first embodiment. In other words, the incident light is reflected in a similar manner by the focus detection pixel 11R and by the focus detection pixel 11L, so that balanced signals are outputted.

### Seventeenth Embodiment

A seventeenth embodiment will now be explained, with attention being principally concentrated upon the features of difference from the first embodiment.

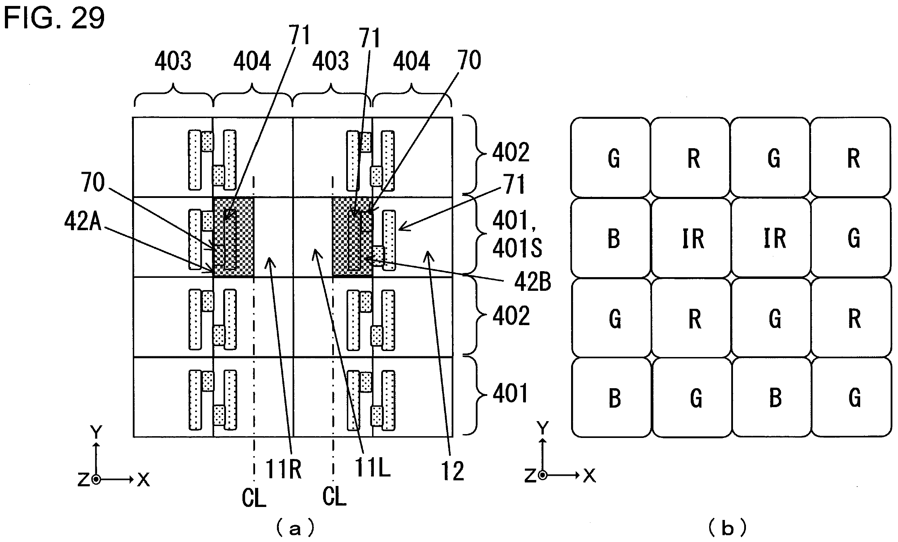

Fig. 29(a) is a plan view, schematically showing the circuit layout of a number of imaging pixels 12 and focus detection pixels 11R, 11L, and Fig. 29(b) is a plan view schematically showing the pattern of arrangement of their color filters. Of the plurality of pixels that are arranged in the region 22a of the image sensor 22 that generates an image (refer to Fig. 3), Fig. 29(a) only shows a total of sixteen pixels arranged in a four row by four column array. And the color filters of the above total of sixteen pixels are shown in Fig. 29(b). In Fig. 29(a), each single pixel is shown by a white square surrounded by a black line.

In this embodiment, color filters of a total of four types are used, with an IR (infrared light) color filter being added to the three types of color filters, i.e. R (red), G (green), and B (blue) color filters. These IR color filters principally pass light of the infrared wavelength range (infrared light). The focus detection pixels 11R, 11L have IR color filters. As shown in Fig. 29, the focus detection pixels 11R, 11L are disposed to replace a G pixel and a B pixel that are mutually adjacent. In the following explanation, among the pixel columns in the vertical direction (i.e. in the column direction), the pixel columns that include B pixels are termed the pixel columns 403. Moreover, among the pixel columns in the vertical direction (i.e. in the column direction), the pixel columns that include R pixels are termed the pixel columns 404.

The gate electrodes 71 of the transfer transistors TX included in the imaging pixels 12 and the focus detection pixels 11R, 11L have the shape of rectangles that extend taller in the vertical direction on the drawing paper (i.e. in the Y axis direction). In the pixels that are disposed in the pixel columns 403, the gate electrodes 71 are disposed more toward the rightward direction on the drawing paper (i.e. toward the +X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward that direction of arrangement (i.e. toward the +X axis direction) than the centers of the corresponding photoelectric conversion units 41.

In the pixels included in the pixel columns 404, the gate electrodes 71 are disposed more toward the leftward direction on the drawing paper (i.e. toward the -X axis direction) than the centers of the corresponding photoelectric conversion units 41. In other words, in a plane that intersects the direction in which light is incident (i.e. the -Z axis direction) and that is parallel to the direction in which the focus detection pixels 11R, 11L are arranged (i.e. the +X axis direction), the gate electrodes 71 are provided more toward a direction opposite to the direction of arrangement (i.e. the +X axis direction) than the centers of the corresponding photoelectric conversion units 41.

The accumulation units 70 of the imaging pixels 12 and the focus detection pixels 11R, 11L have rectangular shapes that are quite tall in the vertical direction upon the drawing paper (i.e. in the Y axis direction). And the sizes of the accumulation units 70 in the Y axis direction are around half the sizes of the photoelectric conversion units 41 in the Y axis direction. And, in the pixels included in the pixel columns 403, the accumulation units 70 are disposed more toward the upward and rightward direction on the drawing paper (i.e. toward the +X axis direction and toward the +Y axis direction) than the gate electrodes 71 of the transfer transistors TX. In other words, in a plane that intersects the direction in which light is incident (i.e. the -Z axis direction) and that is parallel to the direction in which the focus detection pixels 11R, 11L are arranged (i.e. the +X axis direction), the accumulation units 70 are provided more toward the direction of arrangement (i.e. the +X axis direction), and moreover more toward a direction (the +Y axis direction) that intersects the direction of arrangement (i.e. the +X axis direction), than the centers of the corresponding photoelectric conversion units 41.

In the pixels included in the pixel columns 404, the accumulation units 70 are disposed more toward the downward and leftward direction on the drawing paper (i.e. toward the -X axis direction and toward the -Y axis direction) than the gate electrodes 71 of the transfer transistors TX. In other words, in a plane that intersects the direction in which light is incident (i.e. the -Z axis direction) and that is parallel to the direction in which the focus detection pixels 11R, 11L are arranged (i.e. the +X axis direction), the accumulation units 70 are provided more toward a direction opposite to the direction of arrangement (i.e. the +X axis direction), and moreover more toward a direction (the -Y axis direction) that intersects the direction of arrangement (i.e. the +X axis direction), than the centers of the corresponding photoelectric conversion units 41.

The gate electrode 71 of the transfer transistor TX and the accumulation unit 70 are provided upon the optical path of light reflected by the reflective unit 42A. And the gate electrode 71 of the transfer transistor TX and the accumulation unit 70 are provided upon the optical path of light reflected by the reflective unit 42B. The area and the shape of the gate electrode 71 and the accumulation unit 70 at the reflective unit 42A and the area and the shape of the gate electrode 71 and the accumulation unit 70 at the reflective unit 42B are almost equal. Moreover, their positions are almost point symmetric with respect to the center of the photoelectric conversion unit 41. Since those gate electrodes 71 and accumulation units 70 are arranged symmetrically in this manner, accordingly similar beneficial effects are obtained as in the case of the first embodiment. In other words, the incident light is reflected in a similar manner by the focus detection pixel 11R and by the focus detection pixel 11L, so that balanced signals are outputted.

While various embodiments have been explained above, the shapes, the sizes, and the arrangements of the electrodes in those embodiments, and the arrangement of their focus detection pixels 11R, 11L and the arrangement of their color filters and so on, are only given by way of example; it would also be possible to formulate embodiments in which those details are changed.

Moreover it should be understood that, in the various embodiments explained above, it is ensured that the symmetry of the signals outputted by the focus detection pixel 11R and by the focus detection pixel 11L is preserved by arranging members such as the gate electrodes 71 of the focus detection pixel 11R and the focus detection pixel 11L or the like upon the optical paths along which light is incident. However, it would also be acceptable for the shapes, areas, and positions of the members upon the optical paths along which light is incident not to be precisely symmetrical between the reflective units 42A and 42B. For example, it would be acceptable to arrange for the area of a member such as a gate electrode 71 or the like possessed by one of the focus detection pixel 11R and the focus detection pixel 11L that overlaps the reflective unit 42A, 42B to be somewhat larger, or somewhat smaller, than the other thereof. For example, in Fig. 7, the position of the gate electrode 71 of the focus detection pixel 11R may deviate vertically or horizontally to a greater or lesser extent from its position shown in Fig. 7. If such a deviation from symmetry to a greater or lesser extent is present, then it is desirable for the focus detection unit 21a to perform correction processing upon the signals read out from the focus detection pixel 11R and from the focus detection pixel 11L, in order to correct for this deviation.

While various embodiments and modifications have been explained above, the present invention is not to be considered as being limited to the details thereof. Other variations that are considered to come within the range of the technical concept of the present invention are also included within the scope of the present invention.

The disclosure of the following priority application is herein incorporated by reference:
Japanese Patent Application 2016-194624 (filed on 30 September 2016).

### REFERENCE SIGNS LIST

- 1:: camera
- 2:: camera body
- 3:: interchangeable lens
- 12:: imaging pixel
- 11R, 11L:: focus detection pixels
- 21:: body control unit
- 21a:: focus detection unit
- 22:: image sensor
- 31:: imaging optical system
- 40:: micro lens
- 41:: photoelectric conversion unit
- 42A, 42B:: reflective units
- 43:: color filter

## Claims

1. An image sensor in which a plurality of pixels are arranged in a first direction, wherein:
each of a first pixel and a second pixel included in the plurality of pixels comprises a photoelectric conversion unit that photoelectrically converts incident light and generates electric charge, a reflective unit that reflects light that has passed through the photoelectric conversion unit back to the photoelectric conversion unit, and an output unit that outputs electric charge generated by photoelectric conversion by the photoelectric conversion unit;
in a plane intersecting the direction in which light is incident, the reflective unit of the first pixel is provided in a region more toward the first direction than the center of the photoelectric conversion unit of the first pixel;
in a plane intersecting the direction in which light is incident, the reflective unit of the second pixel is provided in a region more toward the direction opposite to the first direction than the center of the photoelectric conversion unit of the second pixel;
at least a portion of the output unit of the first pixel is provided upon the optical path along which light that has passed through the photoelectric conversion unit of the first pixel is incident upon the reflective unit of the first pixel; and
at least a portion of the output unit of the second pixel is provided upon the optical path along which light that has passed through the photoelectric conversion unit of the second pixel is incident upon the reflective unit of the second pixel.

2. The image sensor according to Claim 1, wherein:
in a plane intersecting the direction in which light is incident, the reflective unit of the first pixel is provided, among regions subdivided by a line parallel to a line passing through the center of the photoelectric conversion unit of the first pixel, in a region toward the first direction; and
in a plane intersecting the direction in which light is incident, the reflective unit of the second pixel is provided, among regions subdivided by a line parallel to a line passing through the center of the photoelectric conversion unit of the second pixel, in a region toward the direction opposite to the first direction.

3. The image sensor according to Claim 2, wherein:
in a plane intersecting the direction in which light is incident and parallel to the first direction, the reflective unit of the first pixel is provided, among regions subdivided by a line parallel to a line passing through the center of the photoelectric conversion unit of the first pixel, in a region toward the first direction; and
in a plane intersecting the direction in which light is incident and parallel to the first direction, the reflective unit of the second pixel is provided, among regions subdivided by a line parallel to a line passing through the center of the photoelectric conversion unit of the second pixel, in a region toward the direction opposite to the first direction.

4. The image sensor according to Claim 2 or Claim 3, wherein:
in a plane intersecting the direction in which light is incident and parallel to the first direction, the reflective unit of the first pixel is provided, among regions subdivided by a line orthogonal to a line passing through the center of the photoelectric conversion unit of the first pixel and orthogonal to the plane, in a region toward the first direction; and
in a plane intersecting the direction in which light is incident and parallel to the first direction, the reflective unit of the second pixel is provided, among regions subdivided by a line orthogonal to a line passing through the center of the photoelectric conversion unit of the second pixel and orthogonal to the plane, in a region toward the direction opposite to the first direction.

5. The image sensor according to any one of Claims 1 through 4, wherein:
in a plane intersecting the direction in which light is incident and parallel to the first direction, the output unit of the first pixel is provided more toward a direction that intersects the first direction than the center of the photoelectric conversion unit of the first pixel; and
in a plane intersecting the direction in which light is incident and parallel to the first direction, the output unit of the second pixel is provided more toward a direction that intersects the first direction than the center of the photoelectric conversion unit of the second pixel.

6. The image sensor according to any one of Claims 1 through 4, wherein:
in a plane intersecting the direction in which light is incident and parallel to the first direction, the output unit of the first pixel is provided more toward a third direction that intersects the first direction than the center of the photoelectric conversion unit of the first pixel; and
in a plane intersecting the direction in which light is incident and parallel to the first direction, the output unit of the second pixel is provided more toward a direction opposite to the third direction than the center of the photoelectric conversion unit of the second pixel.

7. The image sensor according to any one of Claims 1 through 4, wherein:
in a plane intersecting the direction in which light is incident and parallel to the first direction, the output unit of the first pixel is provided more toward the first direction than the center of the photoelectric conversion unit of the first pixel; and
in a plane intersecting the direction in which light is incident and parallel to the first direction, the output unit of the second pixel is provided more toward the direction opposite to the first direction than the center of the photoelectric conversion unit of the second pixel.

8. The image sensor according to any one of Claims 1 through 7, wherein the output unit of the first pixel and the output unit of the second pixel have the same areas in planes intersecting the directions in which light is incident.

9. The image sensor according to any one of Claims 1 through 8, wherein the first pixel and the second pixel share the output unit.

10. The image sensor according to any one of Claims 1 through 9, wherein:
the first pixel has a filter that passes a specific wavelength range; and
the second pixel has a filter that passes the specific wavelength range.

11. The image sensor according to any one of Claims 1 through 10, having a pixel row in which the first pixels and the second pixels are provided in the first direction.

12. The image sensor according to any one of Claims 1 through 10, having a pixel column in which the first pixels and the second pixels are provided in a direction that intersects the first direction.

13. The image sensor according to any one of Claims 1 through 10, having a pixel row in which the first pixels are provided in the first direction, and a pixel row in which the second pixels are provided in the first direction.

14. The image sensor according to any one of Claims 1 through 10, having a pixel column in which the first pixels are provided in a direction that intersects the first direction, and a pixel column in which the second pixels are provided in a direction that intersects the first direction.

15. An image sensor, comprising:
a photoelectric conversion unit that photoelectrically converts incident light and generates electric charge;
a reflective unit that reflects light that has passed through the photoelectric conversion unit back to the photoelectric conversion unit; and
an output unit that outputs electric charge generated by photoelectric conversion by the photoelectric conversion unit;
wherein at least a part of the output unit is provided upon the optical path along which light that has passed through the photoelectric conversion unit is incident upon the reflective unit.

16. The image sensor according to any one of Claims 1 through 15, further comprising an accumulation unit that accumulates electric charge generated by the photoelectric conversion unit, and wherein the output unit is a transfer unit that transfers electric charge to the accumulation unit.

17. The image sensor according to Claim 16, wherein the output unit is an electrode of the transfer unit.

18. The image sensor according to any one of Claims 1 through 15, wherein the output unit is a discharge unit that discharges electric charge generated by the photoelectric conversion unit.

19. The image sensor according to any one of Claims 1 through 15, further comprising an accumulation unit that accumulates electric charge generated by the photoelectric conversion unit, and wherein the output unit outputs a signal based upon the voltage of the accumulation unit.

20. A focus adjustment device, comprising:
an image sensor according to any one of claims 1 through 19; and
an adjustment unit that adjusts the focusing position of an imaging optical system on the basis of a signal based upon electric charge outputted from the output unit.
